# EUROPÄISCHE PATENTSCHRIFT

(11) **EP 2 841 977 B1**
(45) Veröffentlichungstag und Bekanntmachung des Hinweises auf die Patenterteilung: **13.10.2021**
(21) Anmeldenummer: 13718572.4
(22) Anmeldetag: 22.04.2013
(51) Int. Cl.: G02B 26/08, G03F 7/20

(54) **OPTISCHES BAUELEMENT ZUR FÜHRUNG EINES STRAHLUNGSBÜNDELS**
OPTICAL COMPONENT FOR GUIDING A RADIATION BEAM
COMPOSANT OPTIQUE POUR LE GUIDAGE D'UN FAISCEAU DE RAYONS

(30) Priorität: 23.04.2012 DE 102012206612; 23.04.2012 US 201261636788 P
(43) Veröffentlichungstag der Anmeldung: 04.03.2015
(73) Patentinhaber: Carl Zeiss SMT GmbH, 73447 Oberkochen (DE)
(72) Erfinder: VÖLCKER, Martin, 89551 Königsbronn (DE); FELDMANN, Heiko, 73430 Aalen (DE); HILLERICH, Bernd, 89073 Ulm (DE)
(74) Vertreter: Rau, Schneck & Hübner Patentanwälte Rechtsanwälte PartGmbB
(86) Internationale Anmeldenummer: PCT/EP2013/058303
(87) Internationale Veröffentlichungsnummer: WO 2013/160256

(56) Entgegenhaltungen:
- EP-A1- 2 045 645
- WO-A1-2010/008993
- WO-A2-2008/095695
- US-A- 3 923 400
- US-A- 5 312 513
- US-A1- 2002 149 834
- US-A1- 2005 219 675
- US-A1- 2006 066 964
- US-A1- 2008 054 757
- US-A1- 2009 115 990
- US-B1- 7 046 411
- PARDO ET AL: "Flexible fabrication of large pixel count piston-tip-tilt mirror arrays for fast spatial light modulators", MICROELECTRONIC ENGINEERING, ELSEVIER PUBLISHERS BV., AMSTERDAM, NL, Bd. 84, Nr. 5-8, 6. Mai 2007 (2007-05-06), Seiten 1157-1161, XP022061969, ISSN: 0167-9317, DOI: 10.1016/J.MEE.2007.01.099
- SPIE, PO BOX 10 BELLINGHAM WA 98227-0010 USA, 14 February 2007 (2007-02-14), XP040235524,

## Beschreibung

Die Erfindung betrifft ein optisches Bauelement zur Führung eines Strahlungsbündels und ein Verfahren zur Herstellung eines derartigen optischen Bauelements. Ferner betrifft die Erfindung ein optisches System zur Bearbeitung und/oder Untersuchung einer Oberfläche. Schließlich betrifft die Erfindung ein Verfahren zur Bearbeitung und/oder Untersuchung einer Oberfläche mit Strahlung mit einer vorgegebenen Hauptstrahlrichtung und/oder Fokustiefe und/oder Lichtverteilung im Fokus.

Ein optisches Bauelement mit einem eine Mehrzahl von aktuatorisch verlagerbaren Einzelspiegeln umfassenden Spiegel ist bekannt aus der US 6,658,084 B2, der WO 2009/100856 A1 und der WO 2010/049076 A2, sowie aus PARDO ET AL: "Flexible fabrication of large pixel count piston-tip-tilt mirrorarrays for fast spatial light modulators", MICROELECTRONIC ENGINEERING, ELSEVIER PUBLISHERS BV., AMSTERDAM, NL, Bd. 84, Nr. 5-8, 6. Mai 2007 (2007-05-06), Seiten 1157-1161, XP022061969, ISSN: 0167-9317, DOI:10.1016/ J.MEE.2007.01.099, US2005219675 A1, US2006066964 A1.

Eine Aufgabe der Erfindung besteht darin, ein derartiges optisches Bauelement zu verbessern.

Diese Aufgabe wird durch die Merkmale des Anspruchs 1 gelöst.

Der Kern der Erfindung besteht darin, zumindest einen Teil der Spiegel-Elemente in einem zweidimensionalen Spiegel-Array derart auszubilden, dass sie mittels elektromagnetischer Aktuatoren sowohl aktuatorisch verkippbar als auch linear verlagerbar sind. Mit anderen Worten kann neben dem Kippwinkel auch die Spiegelhöhe zumindest eines Teils der Spiegel-Elemente des Spiegel-Arrays, insbesondere sämtlicher Spiegel-Elemente des Spiegel-Arrays eingestellt werden. Dies ermöglicht es, die Richtung und Phase des reflektierten Lichtes zu steuern.

Die Aktuatoren sind als elektromagnetische, insbesondere als elektrostatische Aktuatoren ausgebildet. Dies ermöglicht eine sehr präzise und flexible aktuatorische Verlagerung der Spiegel-Elemente. Außerdem sind derartige Aktuatoren auf besonders einfache Weise herstellbar. Vorteilhafterweise umfasst der Aktuator zur Verlagerung der Spiegel-Elemente jeweils mindestens eine mit dem Spiegel-Element verbundene Elektrode und mindestens eine zweite, mit der Tragestruktur verbundene Elektrode. Die mit dem Spiegel-Element verbundene Elektrode ist insbesondere relativ zur Tragestruktur beweglich. Die mit der Tragestruktur verbundene Elektrode ist insbesondere fest mit der Tragestruktur verbunden. Dies führt dazu, dass durch Anlegen einer elektrischen Spannung an die Elektroden eine Kraft auf das Spiegel-Element relativ zur Tragestruktur ausübbar ist. Hierbei ist die auf das Spiegel-Element wirkende Kraft von der Verteilung der Feldstärke des erzeugten elektrischen Feldes und der Anordnung insbesondere der mit dem Spiegel-Element verbundenen Elektrode in diesem elektrischen Feld abhängig. Durch Erzeugung eines elektrischen Feldes, dessen über die Erstreckung der ersten Elektrode gemittelte Feldstärke eine Komponente in Richtung der Flächennormalen aufweist, lässt sich eine in Richtung der Flächennormalen wirkende Kraft auf das Spiegel-Element ausüben. Eine derartige Kraft kann zu einer linearen Verlagerung des Spiegel-Elements führen. Allgemein wirkt auf eine in einem elektrischen Feld angeordnete Elektrode, welche auf einer konstanten Spannung gehalten wird, eine Kraft, welche von der Verteilung der Feldstärke des elektrischen Feldes im Bereich der Elektrode abhängt. Die insgesamt auf diese Elektrode wirkende Kraft ist daher abhängig von der über die Erstreckung der Elektrode gemittelte Feldstärke des elektrischen Feldes. Insbesondere Asymmetrien des elektrischen Feldes bezüglich der geometrischen Ausbildung der Elektrode können zu einer resultierenden, auf die Elektrode wirkenden Gesamtkraft führen. Im Folgenden wird die Richtung der Flächennormalen der Spiegel-Elemente in deren Mittelstellung als z-Richtung bezeichnet.

Bei dem Strahlungsbündel, das mittels des optischen Bauelements geführt wird, kann es sich um ein Teilstrahlungsbündel, also um einen Teil eines gesamten Strahlungsbündels handeln. Bei dem über das optische Bauelement führbaren Strahlungsbündel kann es sich um ein EUV-Strahlungsbündel handeln. Bei dem zu führenden Strahlungsbündel kann es sich auch um Laserstrahlung handeln. Es kann sich um einen einzelnen Strahl oder um eine Vielzahl von Strahlen handeln.

Die Spiegel können in einer regelmäßigen Matrix angeordnet sein.

Eine matrixförmige, also zeilen- und spaltenweise Anordnung der Spiegelkörper in einem zweidimensionalen Array lässt sich mit sehr hoher Integrationsdichte realisieren. Alternative Anordnungen sind je nach Anwendung ebenfalls möglich.

Die mit dem Spiegelkörper verbundene Elektrode kann vorzugsweise auf einem mit dem Spiegelkörper verbundenen Aktuatorstift angeordnet sein. Hierbei erstreckt sich der Aktuatorstift vorteilhafterweise parallel zur z-Richtung auf der der Reflexionsfläche entgegengesetzten Seite des Spiegelkörpers. Dies ermöglicht eine besonders einfache Steuerung der Kippstellung des Spiegel-Elements und dessen Verlagerung in Richtung der Flächennormalen. Die mit der Tragestruktur verbundenen Elektroden sind vorteilhafterweise jeweils auf einer den Aktuatorstift in Richtung quer zur Flächennormalen umgebenden, in der Tragestruktur ausgebildeten Hülse angeordnet. Eine derartige Anordnung der Elektroden ist einerseits auf besonders einfache Weise herstellbar, andererseits ermöglicht sie eine besonders präzise Steuerung der Aktuierung des Spiegelelements.

Eine besonders einfache Möglichkeit, ein elektrisches Feld mit einer über die Erstreckung der mindestens einen ersten Elektrode in z-Richtung variierenden Feldstärke zu erzeugen, ist dadurch gegeben, die Elektroden in z-Richtung gegeneinander versetzt anzuordnen. Unter einer versetzten Anordnung sei hierbei verstanden, dass die mit der Tragestruktur verbundene Elektrode in z-Richtung zwei entgegengesetze Enden aufweist, von denen mindestens eines, insbesondere beide relativ zu entsprechenden Enden der mit dem Spiegelelement verbundenen Elektrode in z-Richtung versetzt sind.

Eine weitere Möglichkeit besteht darin, die Elektroden mit unterschiedlichen Längen in z-Richtung auszubilden. Eine derartige Ausbildung und/oder Anordnung der Elektroden ermöglicht es auf einfache Weise, eine präzise steuerbare Kraft mit einer Komponente in z-Richtung auf das Spiegel-Element auszuüben.

Allgemein weist die mit der Tragestruktur verbundene Elektrode Abmessungen in z-Richtung auf, welche absolut und/oder relativ zu den Abmessungen der mit dem Spiegelelement verbundenen Elektrode in z-Richtung abweichen.

Erfindungsgemäß umfasst u.a. mindestens eine der Elektroden mindestens zwei separate Teil-Elektroden, die in z-Richtung gegeneinander versetzt angeordnet und unabhängig voneinander mit Spannung beaufschlagbar sind. Auch hierdurch lässt sich auf einfache Weise ein elektrisches Feld mit einer in z-Richtung des Spiegel-Elements variierenden Feldstärke erzeugen.

Die mindestens zwei Teil-Elektroden können parallel zueinander sein. Sie sind in z-Richtung gegeneinander versetzt angeordnet. Sie können insbesondere parallel zur z-Richtung ausgerichtet und in z-Richtung hintereinander angeordnet sein.

Es ist auch möglich, mindestens eine der Teil-Elektroden quer, insbesondere senkrecht, zur z-Richtung auszurichten. Hierdurch lässt sich besonders einfach ein elektrisches Feld, welches in z-Richtung einen Gradienten aufweist, erzeugen. Dies führt zu einer Kraft in z-Richtung auf das Spiegel-Element.

Vorteilhafterweise weist das Bauelement eine Steuer-Vorrichtung zur Steuerung der Verlagerung der Spiegel-Elemente auf. Dies kann insbesondere in die Tragestruktur integriert sein. Dies ermöglicht eine besonders platzsparende Anordnung der Steuer-Vorrichtung, was insbesondere bei einer großen Anzahl von Spiegelelementen vorteilhaft ist.

Eine weitere Aufgabe der Erfindung besteht darin, ein Verfahren zur Herstellung eines derartigen optischen Bauelements anzugeben.

Diese Aufgabe wird durch die Merkmale des Anspruchs 6 gelöst. Der Kern der Erfindung besteht darin, einen Teil der Elektroden selektiv zu verkürzen. Hierdurch können auf einfache Weise Elektroden mit der gewünschten geometrischen Ausbildung hergestellt werden. Bei den verkürzten Elektroden handelt es sich insbesondere um die, welche im fertigen optischen Bauelement mit den Spiegel-Elementen verbunden sind. Sie sind insbesondere auf der Oberfläche eines mit dem Spiegelkörper eines Spiegel-Elements jeweils verbundenen Aktuator- oder Elektrodenstiftes ausgebildet. Allgemein weist die mit der Tragestruktur verbundene Elektrode Abmessungen in z-Richtung auf, welche absolut und/oder relativ zu den Abmessungen der mit dem Spiegelelement verbundenen Elektrode in z-Richtung abweichen. Ebenso ist es möglich, die Struktur, auf welcher die Elektrode, welche im fertigen optischen Bauelement mit einem der Spiegel-Elemente verbunden ist, angeordnet ist, d. h. den Aktuatorstift, vor Herstellung der Elektrode zu verkürzen. Alternativ können auch die äußeren, d. h. mit der Tragestruktur verbundenen Elektroden verkürzt werden. Zum Verkürzen der Elektroden, insbesondere des Aktuatorstiftes, ist vorteilhafterweise ein Ätzverfahren vorgesehen. Die Herstellung der Elektroden mit der gewünschten geometrischen Struktur lässt sich somit auf besonders einfache Weise in den Herstellungsprozess des optischen Bauelements integrieren.

Eine weitere Aufgabe der Erfindung besteht darin, ein optisches System zur Bearbeitung und/oder Untersuchung einer Oberfläche zu verbessern. Diese Aufgabe wird durch die Merkmale des Anspruchs 7 gelöst. Die Vorteile entsprechen denjenigen, welche für das optische Bauelement beschrieben wurden.

Es kann sich insbesondere um ein Einstrahlsystem mit einem einzigen Fokus handeln. Es kann sich auch um ein Vielstrahlsystem mit einer Vielzahl von Strahlen, insbesondere einer Mehrzahl von Foki handeln. Bei der Strahlungsquelle kann es sich um einen Laser handeln. Es kann sich auch um eine LED-Strahlungsquelle, Laserdioden(-arrays), eine Entladungslampe, eine Halogenlampe oder eine EUV-Strahlungsquelle handeln.

Bei dem optischen System handelt es sich insbesondere um eine Laserbearbeitungsanlage, ein System zur Lasermarkierung oder um ein System zur Laserbehandlung, insbesondere für medizinische Zwecke. Es kann sich auch um ein Beleuchtungssystem für eine Projektionsbelichtungsanlage, insbesondere eine EUV-Projektionsbelichtungsanlage handeln. Es kann sich auch um ein System zur dreidimensionalen Bildaufnahme, insbesondere zur dreidimensionalen Erfassung der topografischen Struktur einer Oberfläche handeln. Es kann sich auch um ein System zur lokalen Lichtanregung (Photomanipulation) als Teil eines Mikroskopsystems handeln.

Vorzugsweise weist das optische System eine verstellbare Brennweite, insbesondere eine erweiterte Fokustiefe auf. Hierunter sei verstanden, dass die Brennweite des optischen Bauelements durch die aktuatorische Verlagerung der Spiegelelemente veränderbar, insbesondere in einem großen Bereich veränderbar ist. Die Fokustiefe des optischen Systems beträgt insbesondere mindestens 1 mm, insbesondere mindestens 1 cm, insbesondere mindestens 1 dm. Sie kann auch mindestens 1 m betragen. Dies ist insbesondere zur Bearbeitung und/oder Untersuchung einer aplanaren Oberfläche, insbesondere einer dreidimensional strukturierten Oberfläche vorteilhaft. Prinzipiell können Strahlenbündel durch aktuatorische Verlagerung der Spiegelelemente des optischen Bauelements auf eine beliebig gekrümmte zu bearbeitende oder zu untersuchende Oberfläche fokussiert werden.

Vorzugsweise weist das optische System eine verstellbare Hauptstrahlrichtung auf. Hierdurch lässt sich insbesondere ein variabler Einfallswinkel der Strahlung auf die zu bearbeitende und/oder zu untersuchende Oberfläche erreichen. Es kann insbesondere erreicht werden, dass die Strahlung stets unter einem kleinen Einfallswinkel, insbesondere unter einem Einfallswinkel von höchstens 10°, insbesondere höchstens 5°, insbesondere höchstens 3° auf die zu bearbeitende und/oder zu untersuchende Oberfläche auftrifft. Hierbei wird der Einfallswinkel jeweils relativ zur Normalen der Oberfläche an einem gegebenen Punkt gemessen. Durch die verstellbare Hauptstrahlrichtung lässt sich insbesondere erreichen, dass die Strahlung auch bei einer beliebig gekrümmten Oberfläche in den unterschiedlichen Punkten der Oberfläche mit einem derartig kleinen Winkel auf diese auftrifft.

Gemäß einem Aspekt der Erfindung kann das optische System eine Detektions-Einrichtung zur konfokalen Bestimmung einer Entfernung zwischen dem optischen Bauelement und der zu bearbeitenden und/oder zu untersuchenden Oberfläche aufweisen. Die Detektions-Einrichtung kann insbesondere Bestandteil einer Regelschleife sein. Mittels der Regelschleife kann die Fokustiefe kontinuierlich derart geregelt werden, dass die Strahlung stets auf die zu bearbeitende und/oder zu untersuchende Oberfläche fokussiert ist. Die Regelschleife bildet insbesondere eine Autofokus-Einrichtung.

Es kann vorteilhaft sein, im Strahlengang zwischen der Strahlungsquelle und dem optischen Bauelement mindestens einen verkippbaren Spiegel anzuordnen. Durch Verkippung dieses Spiegels kann der Strahlengang von der Strahlungsquelle auf unterschiedliche Bereiche des optischen Bauelements und von dort auf die zu bearbeitende und/oder zu untersuchende Oberfläche gelenkt werden. Der verkippbar gelagerte Spiegel kann insbesondere mit einer zentralen Steuereinrichtung verbunden sein. Es ist auch möglich, das optische Bauelement selbst, das heißt das Multi-Spiegelarray, verkippbar zu lagern.

An reflektierenden Oberflächen kann gemessen werden, ob der Strahl senkrecht auf die Oberfläche auftrifft. So kann die Hauptstrahlrichtung derart geregelt werden, dass der Strahl auch bei gekrümmten Oberflächen senkrecht auftrifft.

Im Strahlengang zwischen der Strahlungsquelle und dem optischen Bauelement kann ein Strahlteiler angeordnet sein. Als Strahlteiler kann insbesondere ein halbdurchlässiger Spiegel dienen.

Der Strahlteiler kann insbesondere derart ausgebildet sein, dass er die Strahlung von der Strahlungsquelle zum optischen Bauelement und damit zu der zu bearbeitenden und/oder zu untersuchenden Oberfläche passieren lässt, während er die von dieser Oberfläche reflektierte Strahlung zum Detektor der Detektions-Einrichtung umlenkt.

Eine weitere Aufgabe der Erfindung besteht darin, ein Verfahren zur Bearbeitung und/oder Untersuchung einer Oberfläche mit Strahlung zu verbessern. Diese Aufgabe wird durch die Merkmale des Anspruchs 13 gelöst.

Der Kern der Erfindung besteht darin, die Hauptstrahlrichtung und/oder Brennweite und/oder Strahlverteilung durch aktuatorische Verlagerung der Kippwinkel und/oder Spiegelhöhe zumindest eines Teils der Spiegelelemente einzustellen.

Dies geschieht insbesondere mittels einer zentralen Steuereinrichtung, vorzugsweise mittels einer Regeleinrichtung, welche eine Detektions-Einrichtung umfasst. Mittels der Detektions-Einrichtung ist insbesondere die von der zu bearbeitenden und/oder zu untersuchenden Oberfläche reflektierende Strahlung erfassbar.

Weitere Details und Einzelheiten der Erfindung ergeben sich aus der Beschreibung mehrerer Ausführungsbeispiele anhand der Zeichnungen. Es zeigen:
- Fig. 1: schematisch eine Projektionsbelichtungsanlage für die Mikrolithografie mit einer im Meridionalschnitt dargestellten Beleuchtungsoptik und einer Proj ektionsoptik;
- Fig. 2: eine Ausleuchtung einer Eintrittspupille der Projektionsoptik in Form eines konventionellen Beleuchtungssettings;
- Fig. 3: eine Ausleuchtung einer Eintrittspupille der Projektionsoptik in Form eines annularen, also ringförmigen, Beleuchtungssettings;
- Fig. 4: eine Ausleuchtung einer Eintrittspupille der Projektionsoptik in Form eines 45°-Quadrupol-Beleuchtungssettings;
- Fig. 5: eine Darstellung einer Beleuchtungsoptik der Projektionsbelichtungsanlage nach Fig. 1 mit einem Multispiegel-Array (MMA) und einem von diesem beleuchteten Pupillenfacettenspiegel;
- Fig. 6: schematisch eine Aufsicht auf den Pupillenfacettenspiegel nach Fig. 5 mit einer Pupillenfacetten-Ausleuchtung, die einem Beleuchtungssetting entspricht;
- Fig. 7: die Beleuchtungsoptik nach Fig. 5 mit einer umgestellten Kanalzuordnung des Multispiegel-Arrays zum Pupillenfacettenspiegel;
- Fig. 8: schematisch eine Aufsicht auf den Pupillenfacettenspiegel nach Fig. 7 mit einer Pupillenfacetten-Ausleuchtung, die einem annularen Beleuchtungssetting entspricht;
- Fig. 9: die Beleuchtungsoptik nach Fig. 5 mit einer umgestellten Kanalzuordnung des Multispiegel-Arrays zum Pupillenfacettenspiegel;
- Fig. 10: schematisch eine Aufsicht auf den Pupillenfacettenspiegel nach Fig. 9 mit einer Pupillenfacetten-Ausleuchtung, die einem Dipol-Beleuchtungssetting entspricht;
- Fig. 11: schematisch zwei nebeneinander liegende Einzelspiegel einer Ausführung eines der Facettenspiegel der Beleuchtungsoptik nach Fig. 1 bzw. des Multispiegel-Arrays nach Fig. 5, 7 oder 9 in einer geschnittenen Seitenansicht, wobei der in der Fig. 11 links dargestellte Einzelspiegel in einer unverkippten Neutralstellung und der in der Fig. 11 rechts dargestellte Einzelspiegel in einer durch den Aktuator verkippten Stellung dargestellt ist;
- Fig. 12: einen Schnitt gemäß Linie XII - XII in Fig. 11;
- Fig. 13a und Fig. 13b: schematische Darstellungen der Details der Elektroden des Aktuators zur Verlagerung des Spiegel-Elements und deren Aktivierung gemäß einem Vergleichsbeispiel, das nicht unter die Erfindung fällt;
- Fig. 14a und Fig. 14b: schematische Darstellungen der Details der Elektroden des Aktuators zur Verlagerung des Spiegel-Elements und deren Aktivierung gemäß einem Ausführungsbeispiel;
- Fig. 15a und Fig. 15b: schematische Darstellungen der Details der Elektroden des Aktuators zur Verlagerung des Spiegel-Elements und deren Aktivierung gemäß einem weiteren Ausführungsbeispiel;
- Fig. 16: schematisch Verfahrensschritte eines Verfahrensablaufs zur Herstellung von Gegenelektroden eines Aktuators zur Verlagerung eines Spiegelkörpers des Einzelspiegels im Vergleichsbeispiel nach den Fig. 11 und 12;
- Fig. 17: schematisch einen Querschnitt durch ein Bauelement senkrecht zu Reflexionsflächen der Einzelspiegel, wobei zusätzlich zu einer schematisch dargestellten Spiegelplatte mit einer Array-Anordnung der Einzelspiegel eine Ansteuerungsplatine zur Ansteuerung der Aktuatoren der Einzelspiegel dargestellt ist;
- Fig. 18: schematisch ein Ansteuerungsschema für eine Mehrzahl von Teil-Einzelspiegelarrays des optischen Bauelements;
- Fig. 19: eine Scanoptik mit erweiterter Fokustiefe zur Bearbeitung gekrümmter Flächen;
- Fig. 20: eine Vielstrahl-Scanoptik mit erweiterter Fokustiefe zur Bearbeitung gekrümmter Oberflächen;
- Fig. 21: eine Scanoptik gemäß Fig. 19, mit einem zusätzlichen konfokalen Autofokus und
- Fig. 22: eine Vielstrahl-Scanoptik gemäß Fig. 20 mit paralellem konfokalen Autofokus.

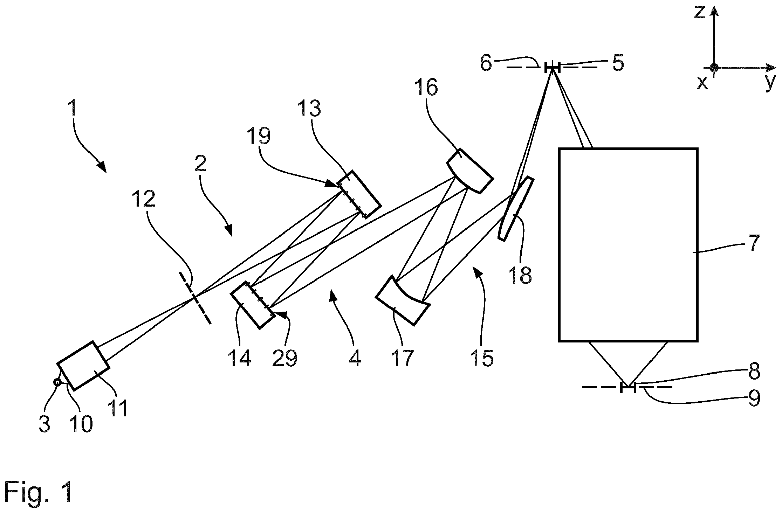

Im Folgenden werden zunächst unterschiedliche Ausführungsformen eines optischen Bauelements und dessen Verwendung in einer Projektionsbelichtungsanlage beschrieben. Weitere Anwendungsmöglichkeiten werden anschließend beschrieben. Fig. 1 zeigt schematisch in einem Meridionalschnitt eine Projektionsbelichtungsanlage 1 für die Mikrolithografie. Für allgemeine Details des Aufbaus der Projektionsbelichtungsanlage 1 sowie deren Bestandteile sei auf die WO 2010/049076 A2 verwiesen. Zur Erleichterung der Erläuterung von Lagebeziehungen wird nachfolgend in ausgewählten Figuren ein globales kartesisches xyz-Koordinatensystem verwendet. Die x-Achse verläuft in der Fig. 1 senkrecht zur Zeichenebene auf den Betrachter zu. Die y-Achse verläuft in der Fig. 1 nach rechts. Die z-Achse verläuft in der Fig. 1 nach oben.

Ein Beleuchtungssystem 2 der Projektionsbelichtungsanlage 1 hat neben einer Strahlungsquelle 3 eine Beleuchtungsoptik 4 zur Belichtung eines Objektfeldes 5 in einer Objektebene 6. Das Objektfeld 5 kann rechteckig oder bogenförmig mit einem x/y-Aspektverhältnis von beispielsweise 13/1 gestaltet sein. Belichtet wird hierbei ein im Objektfeld 5 angeordnetes und in der Fig. 1 nicht dargestelltes reflektierendes Retikel, das eine mit der Projektionsbelichtungsanlage 1 zur Herstellung mikro- bzw. nanostrukturierter Halbleiter-Bauelemente zu projizierende Struktur trägt. Eine Projektionsoptik 7 dient zur Abbildung des Objektfeldes 5 in ein Bildfeld 8 in einer Bildebene 9. Abgebildet wird die Struktur auf dem Retikel auf eine lichtempfindliche Schicht eines im Bereich des Bildfeldes 8 in der Bildebene 9 angeordneten Wafers, der in der Zeichnung nicht dargestellt ist.

Das Retikel, das von einem nicht dargestellten Retikelhalter gehalten ist, und der Wafer, der von einem nicht dargestellten Waferhalter gehalten ist, werden beim Betrieb der Projektionsbelichtungsanlage 1 synchron in der y-Richtung gescannt. Abhängig vom Abbildungsmaßstab der Projektionsoptik 7 kann auch ein gegenläufiges Scannen des Retikels relativ zum Wafer stattfinden.

Bei der Strahlungsquelle 3 handelt es sich um eine EUV-Strahlungsquelle mit einer emittierten Nutzstrahlung mit einer Wellenlänge im Bereich zwischen 5 nm und 30 nm, insbesondere im Bereich zwischen 10 nm und 15 nm. Es kann sich dabei um eine Plasmaquelle, beispielsweise um eine GDPP-Quelle (Plasmaerzeugung durch Gasentladung, Gas Discharge Produced Plasma), oder um eine LPP-Quelle (Plasmaerzeugung durch Laser, Laser Produced Plasma) handeln. Auch andere EUV-Strahlungsquellen, beispielsweise solche, die auf einem Synchrotron oder auf einem Free Electron Laser (Freie Elektronenlaser, FEL) basieren, sind möglich.

EUV-Strahlung 10, die von der Strahlungsquelle 3 ausgeht, wird von einem Kollektor 11 gebündelt. Ein entsprechender Kollektor ist beispielsweise aus der EP 1 225 481 A bekannt. Nach dem Kollektor 11 propagiert die EUV-Strahlung 10 durch eine Zwischenfokusebene 12, bevor sie auf einen Feldfacettenspiegel 13 mit einer Vielzahl von Feldfacetten 19 trifft. Der Feldfacettenspiegel 13 ist in einer Ebene der Beleuchtungsoptik 4 angeordnet, die zur Objektebene 6 optisch konjugiert ist.

Die EUV-Strahlung 10 wird nachfolgend auch als Nutzstrahlung, Beleuchtungslicht oder als Abbildungslicht bezeichnet.

Nach dem Feldfacettenspiegel 13 wird die EUV-Strahlung 10 von einem Pupillenfacettenspiegel 14 mit einer Vielzahl von Pupillenfacetten 29 reflektiert. Der Pupillenfacettenspiegel 14 liegt entweder in der Eintrittspupillenebene der Beleuchtungsoptik 7 oder in einer hierzu optisch konjugierten Ebene. Der Feldfacettenspiegel 13 und der Pupillenfacettenspiegel 14 sind aus einer Vielzahl von auch als Einzelspiegel bezeichneten Spiegel-Elementen 27 aufgebaut, die nachfolgend noch näher beschrieben werden. Dabei kann die Unterteilung des Feldfacettenspiegels 13 in Einzelspiegel 27 derart sein, dass jede der Feldfacetten 19, die für sich das gesamte Objektfeld 5 ausleuchten, durch genau einen der Einzelspiegel 27 repräsentiert wird. Alternativ ist es möglich, zumindest einige oder alle der Feldfacetten 19 durch eine Mehrzahl derartiger Einzelspiegel 27 aufzubauen. Entsprechendes gilt für die Ausgestaltung der den Feldfacetten 19 jeweils zugeordneten Pupillenfacetten 29 des Pupillenfacettenspiegels 14, die jeweils durch einen einzigen Einzelspiegel 27 oder durch eine Mehrzahl derartiger Einzelspiegel 27 gebildet sein können.

Die EUV-Strahlung 10 trifft auf die beiden Facettenspiegel 13, 14 unter einem Einfallswinkel auf, der kleiner oder gleich 25° ist. Die beiden Facettenspiegel werden also im Bereich eines normal incidence-Betriebs mit der EUV-Strahlung 10 beaufschlagt. Auch eine Beaufschlagung unter streifendem Einfall (grazing incidence) ist möglich. Der Pupillenfacettenspiegel 14 ist in einer Ebene der Beleuchtungsoptik 4 angeordnet, die eine Pupillenebene der Projektionsoptik 7 darstellt bzw. zu einer Pupillenebene der Projektionsoptik 7 optisch konjugiert ist. Mithilfe des Pupillenfacettenspiegels 14 einer Übertragungsoptik 15 mit in der Reihenfolge des Strahlengangs für die EUV-Strahlung 10 bezeichneten Spiegeln 16, 17 und 18 werden die Feldfacetten 19 des Feldfacettenspiegels 13 einander überlagernd in das Objektfeld 5 abgebildet. Der letzte Spiegel 18 der Übertragungsoptik 15 ist ein Spiegel für streifenden Einfall ("Grazing incidence Spiegel"). Die Übertragungsoptik 15 wird zusammen mit dem Pupillenfacettenspiegel 14 auch als Folgeoptik zur Überführung der EUV-Strahlung 10 vom Feldfacettenspiegel 13 hin zum Objektfeld 5 bezeichnet. Das Beleuchtungslicht 10 wird von der Strahlungsquelle 3 hin zum Objektfeld 5 über eine Mehrzahl von Ausleuchtungskanälen oder Strahlungskanälen geführt. Bei der Beleuchtungsoptik 4 handelt es sich somit um eine Mehrkanaloptik. Sie wird auch als Vielstrahlsystem bezeichnet. Jedem der Ausleuchtungskanäle ist eine Feldfacette 19 des Feldfacettenspiegels 13 und eine dieser nachgeordnete Pupillenfacette 29 des Pupillenfacettenspiegels 14 zugeordnet. Die Einzelspiegel 27 des Feldfacettenspiegels 13 und/oder des Pupillenfacettenspiegels 14 sind aktuatorisch verkippbar, sodass ein Wechsel der Zuordnung der Pupillenfacetten 29 zu den Feldfacetten 19 und entsprechend eine geänderte Konfiguration der Ausleuchtungskanäle erreicht werden kann. Es resultieren unterschiedliche Beleuchtungssettings, die sich in der Verteilung der Beleuchtungswinkel des Beleuchtungslichts 10 über das Objektfeld 5 unterscheiden. Beim Beleuchtungssystem 2 handelt es sich insbesondere um ein Vielstrahlsystem.

Zumindest ein Teil der Spiegel-Elemente 27 des Feldfacettenspiegels 13 und/oder des Pupillenfacettenspiegels 14 ist aktuatorisch linear in z-Richtung verlagerbar. Die z-Richtung entspricht hierbei gerade der Richtung einer zentralen Flächennormalen 340 der Spiegel-Elemente 27 in deren Mittelstellung. Bei den linear verlagerbaren Spiegelelementen 27 handelt es sich insbesondere zumindest teilweise um die Spiegelelemente 27, welche auch verkippbar sind.

Durch eine derartige lineare Verlagerung, d.h. durch eine Einstellung der Spiegelhöhe, lässt sich insbesondere die Phase der jeweils von dem Einzelspiegel 27 reflekierten Nutzstrahlung 10 steuern.

Prinzipiell können auch andere Spiegel als die Facettenspiegel 13, 14, insbesondere auch Spiegel der Projektionsoptik 7 mit verlagerbaren Einzelspiegeln 27 ausgebildet sein.

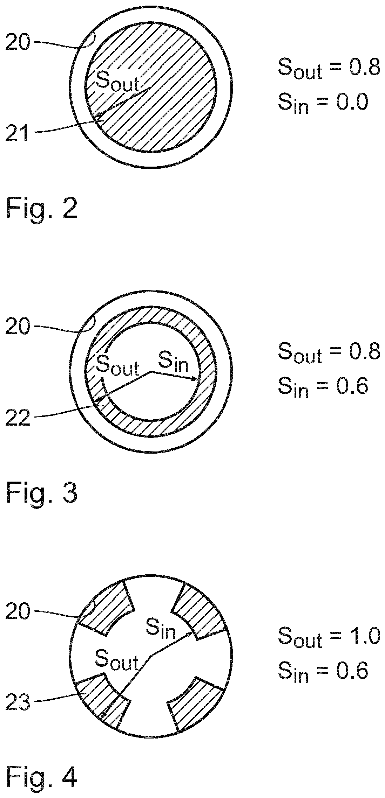

Fig. 2 zeigt ein erstes Beleuchtungssetting, das mit der Beleuchtungsoptik 4 nach Fig. 1 erreicht werden kann und das als konventionelles Beleuchtungssetting oder als kleines konventionelles Beleuchtungssetting bezeichnet wird. Dargestellt ist eine Intensitätsverteilung des Beleuchtungslichts 10 in einer Eintrittspupille der Projektionsoptik 7. Die Eintrittspupille kann maximal bis zu einem kreisförmigen Pupillenrand 20 ausgeleuchtet werden.

Beim konventionellen Beleuchtungssetting wird innerhalb des Pupillenrandes 20 ein hierzu konzentrischer kreisförmiger Pupillenbereich 21 ausgeleuchtet. Ein äußerer Radius Sₒᵤₜ des konventionellen Pupillen-Ausleuchtungsbereichs verhält sich zum Radius Sₘₐₓ des Pupillenrandes 20 wie folgt: Sₒᵤₜ/Sₘₐₓ=0,8.

Fig. 3 zeigt die Beleuchtungsverhältnisse bei einem weiteren Beleuchtungssetting, das mit der Beleuchtungsoptik 4 nach Fig. 1 eingestellt werden kann und das als annulares Beleuchtungssetting bezeichnet wird. Ausgeleuchtet wird hierbei ein ringförmiger Pupillenbereich 22. Ein äußerer Radius Sₒᵤₜ des Pupillenbereichs 22 ist dabei so groß, wie derjenige des Pupillenbereichs 21 beim konventionellen Beleuchtungsring nach Fig. 2. Ein innerer Radius Sᵢₙ verhält sich beim annularen Pupillenbereich 22 zum Radius Sₘₐₓ des Pupillenrandes 20 wie folgt: Sᵢₙ/Sₘₐₓ=0,6.

Fig. 4 zeigt ein weiteres Beleuchtungssetting, das mit der Beleuchtungsoptik 4 nach Fig. 1 eingestellt werden kann und das als 45°-Quadrupol- bzw. 45°-Quasar-Beleuchtungssetting bezeichnet wird. In der Eintrittspupille der Projektionsoptik 7 werden innerhalb des Pupillenrandes 20 vier ringsektorförmige Pupillenbereiche 23 ausgeleuchtet, die in den vier Quadranten der Eintrittspupille angeordnet sind. Jeder der Pupillenbereiche 23 überstreicht dabei um das Zentrum des Pupillenrandes 20 einen Umfangswinkel von 45°. Die Quasar-Pupillenbereiche 23 sind zum Zentrum des Pupillenrandes 20 hin von einem inneren Radius Sin begrenzt, der dem inneren Radius des annularen Pupillenbereichs 22 nach Fig. 3 entspricht. Nach außen hin sind die Quasar-Pupillenbereiche 23 durch den Pupillenrand 20 begrenzt.

Die verschiedenen Beleuchtungssettings nach den Fig. 2 bis 4 sowie vorgegebene weitere Beleuchtungssettings können über eine entsprechende Verkippung der Einzelspiegel 27 des Feldfacettenspiegels 13 und einen entsprechenden Wechsel der Zuordnung der Facetten 19 des Feldfacettenspiegels 13 zu den Facetten 29 des Pupillenfacettenspiegels 14 erreicht werden. Abhängig von der Verkippung der Einzelspiegel 27 des Feldfacettenspiegels 13 werden die diesen Einzelspiegeln 27 neu zugeordneten Einzelspiegel 27 des Pupillenfacettenspiegels 14 so durch Verkippung nachgeführt, dass wiederum eine Abbildung der Feldfacetten 19 des Feldfacettenspiegels 13 in das Objektfeld 5 gewährleistet ist.

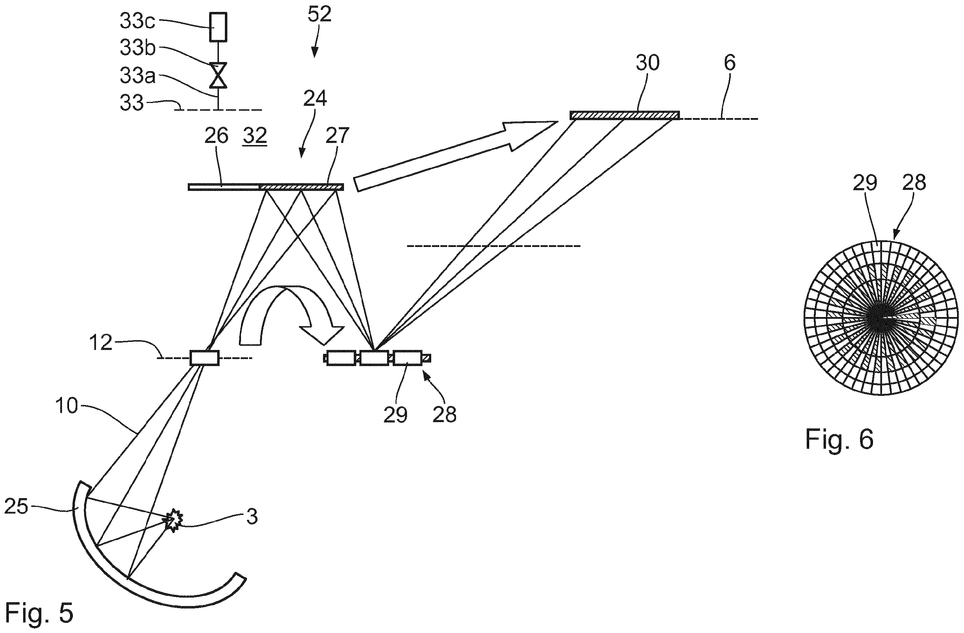

Fig. 5 zeigt eine weitere Darstellung einer Beleuchtungsoptik 24 für die Projektionsbelichtungsanlage 1. Komponenten, die denjenigen entsprechen, die vorstehend unter Bezugnahme auf die Fig. 1 bis 4 bereits erläutert wurden, tragen die gleichen Bezugsziffern und werden nicht nochmals im Einzelnen diskutiert.

Von der Strahlungsquelle 3, die als LPP-Quelle ausgebildet sein kann, ausgehende Nutzstrahlung 10 wird zunächst von einem ersten Kollektor 25 gesammelt. Bei dem Kollektor 25 kann es sich um einen Parabolspiegel handeln, der die Strahlungsquelle 3 in die Zwischenfokusebene 12 abbildet bzw. das Licht der Strahlungsquelle 3 auf den Zwischenfokus in der Zwischenfokusebene 12 fokussiert. Der Kollektor 25 kann so betrieben werden, dass er vor der Nutzstrahlung 10 mit Einfallswinkeln nahe 0 ° beaufschlagt wird. Der Kollektor 25 wird dann nahe der senkrechten Inzidenz (normal incidence) betrieben und daher auch als normal incidence-(NI-)Spiegel bezeichnet. Auch ein unter streifendem Einfall betriebener Kollektor kann anstelle des Kollektors 25 zum Einsatz kommen.

Der Zwischenfokusebene 12 ist bei der Beleuchtungsoptik 24 ein Feldfacettenspiegel 26 in Form eines Multi- bzw. Mikrospiegel-Arrays (MMA) als Beispiel für ein optisches Bauelement 52 zur Führung der Nutzstrahlung 10, also des Strahlungsbündels, nachgeordnet. Der Feldfacettenspiegel 26 ist als mikroelektromechanisches System (MEMS) ausgebildet. Er weist eine Vielzahl von matrixartig zeilen- und spaltenweise in einem zweidimensionalen Array angeordneten Einzelspiegeln 27 auf. Die Einzelspiegel 27 sind aktuatorisch verlagerbar ausgelegt, wie nachfolgend noch erläutert wird.

Insgesamt weist der Feldfacettenspiegel 26 etwa 100000 der Einzelspiegel 27 auf. Je nach Größe der Einzelspiegel 27 kann der Feldfacettenspiegel 26 auch beispielsweise 1000, 5000, 7000 oder auch mehrere hunderttausend, beispielsweise 500000 Einzelspiegel 27 aufweisen.

Vor dem Feldfacettenspiegel 26 kann ein Spektralfilter angeordnet sein, der die Nutzstrahlung 10 von anderen, nicht für die Projektionsbelichtung nutzbaren Wellenlängenkomponenten der Emission der Strahlungsquelle 3 trennt. Der Spektralfilter ist nicht dargestellt.

Der Feldfacettenspiegel 26 wird mit Nutzstrahlung 10 mit einer Leistung von 840 W und einer Leistungsdichte von 6,5 kW/m² beaufschlagt.

Das gesamte Spiegel-Array des Facettenspiegels 26 hat einen Durchmesser von 500 mm und ist dicht gepackt mit den Einzelspiegeln 27 ausgelegt. Die Einzelspiegel 27 repräsentieren, soweit eine Feldfacette 19 durch jeweils genau einen Einzelspiegel 27 realisiert ist, bis auf einen Skalierungsfaktor die Form des Objektfeldes 5. Der Facettenspiegel 26 kann aus 500 jeweils eine Feldfacette 19 repräsentierenden Einzelspiegeln 27 mit einer Dimension von etwa 5 mm in der y-Richtung und 100 mm in der x-Richtung gebildet sein. Alternativ zur Realisierung jeder Feldfacette 19 durch genau einen Einzelspiegel 27 kann jede der Feldfacetten 19 durch Gruppen von kleineren Einzelspiegeln 27 approximiert werden. Eine Feldfacette 19 mit Dimensionen von 5 mm in der y-Richtung und von 100 mm in der x-Richtung kann z. B. mittels eines 1 x 20-Arrays von Einzelspiegeln 27 der Dimension 5 mm x 5 mm bis hin zu einem 10 x 200-Array von Einzelspiegeln 27 mit den Dimensionen 0,5 mm x 0,5 mm aufgebaut sein. Die Flächenabdeckung des kompletten Feldfacetten-Arrays durch die Einzelspiegel 27 kann mindestens 70 %, insbesondere mindestens 80 % betragen.

Von den Einzelspiegeln 27 des Facettenspiegels 26 wird das Nutzlicht 10 hin zu einem Pupillenfacettenspiegel 28 reflektiert. Der Pupillenfacettenspiegel 28 hat etwa 2000 Pupillenfacetten 29. Die Pupillenfacetten 29 können statisch oder flexibel, das heißt verlagerbar, ausgebildet sein. Diese sind in einer Mehrzahl konzentrischer Ringe nebeneinander angeordnet, sodass die Pupillenfacette 29 des innersten Rings sektorförmig und die Pupillenfacetten 29 der sich hieran unmittelbar anschließenden Ringe ringsektorförmig gestaltet sind. In einem Quadranten des Pupillenfacettenspiegels 28 können in jedem der Ringe Pupillenfacetten 29 nebeneinander vorliegen. Jeder der in der Fig. 6 dargestellten Ringsektoren ist wiederum von einer Mehrzahl von Einzelspiegeln 27 gebildet.

Von den Pupillenfacetten 29 wird das Nutzlicht 10 hin zu einem reflektierenden Retikel 30 reflektiert, das in der Objektebene 6 angeordnet ist. Es schließt sich dann die Projektionsoptik 7 an, wie vorstehend im Zusammenhang mit der Projektionsbelichtungsanlage nach Fig. 1 erläutert.

Zwischen dem Facettenspiegel 28 und dem Retikel 30 kann wiederum eine Übertragungsoptik vorgesehen sein, wie vorstehend in Zusammenhang mit der Beleuchtungsoptik 4 nach Fig. 1 erläutert.

Fig. 6 zeigt beispielhaft eine Ausleuchtung der Pupillenfacetten 29 des Pupillenfacettenspiegels 28, mit der angenähert das konventionelle Beleuchtungssetting nach Fig. 2 erreicht werden kann. In den beiden inneren Pupillenfacettenringen des Pupillenfacettenspiegels 28 wird in Umfangsrichtung jede zweite der Pupillenfacetten 29 beleuchtet. Diese alternierende Beleuchtungsdarstellung in der Fig. 6 soll symbolisieren, dass die bei diesem Beleuchtungssetting realisierte Füllungsdichte um einen Faktor 2 geringer ist als bei einem annularen Beleuchtungssetting. Angestrebt wird in den beiden inneren Pupillenfacettenringen ebenfalls eine homogene Beleuchtungsverteilung, allerdings mit um einen Faktor 2 geringerer Belegungsdichte. Die beiden äußeren in Fig. 6 dargestellten Pupillenfacettenringe werden nicht beleuchtet.

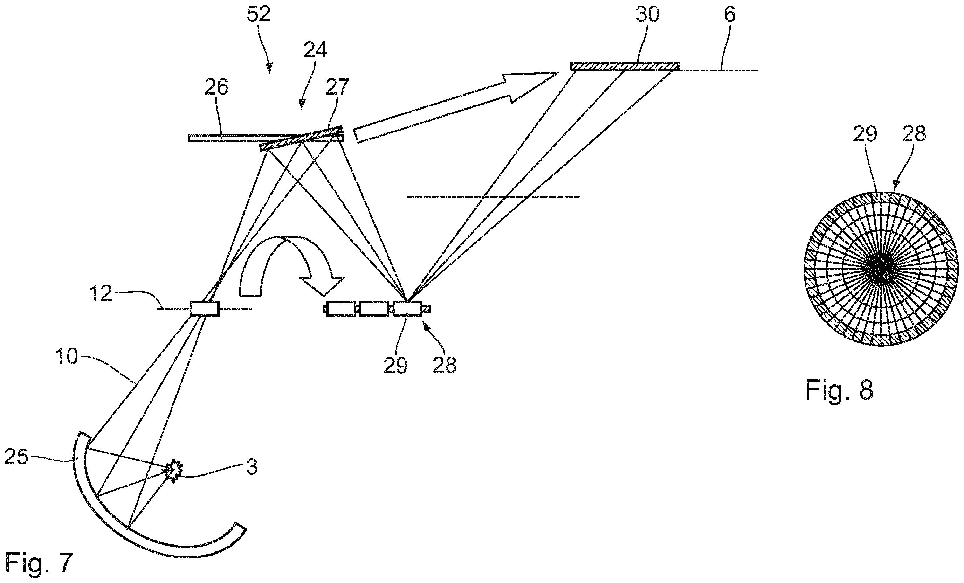

Fig. 7 zeigt schematisch die Verhältnisse bei der Beleuchtungsoptik 24, soweit dort ein annulares Beleuchtungssetting eingestellt ist. Die Einzelspiegel 27 des Feldfacettenspiegels 26 sind derart aktuatorisch mit Hilfe nachfolgend noch erläuterter Aktuatoren verkippt, sodass auf dem Pupillenfacettenspiegel 28 ein äußerer Ring der ringsektorförmigen Pupillenfacette 29 mit dem Nutzlicht 10 beleuchtet ist. Diese Beleuchtung des Pupillenfacettenspiegels 28 ist in der Fig. 8 dargestellt. Die Verkippung der Einzelspiegel 27 zur Erzeugung dieser Beleuchtung ist in der Fig. 7 am Beispiel eines der Einzelspiegel 27 beispielhaft angedeutet.

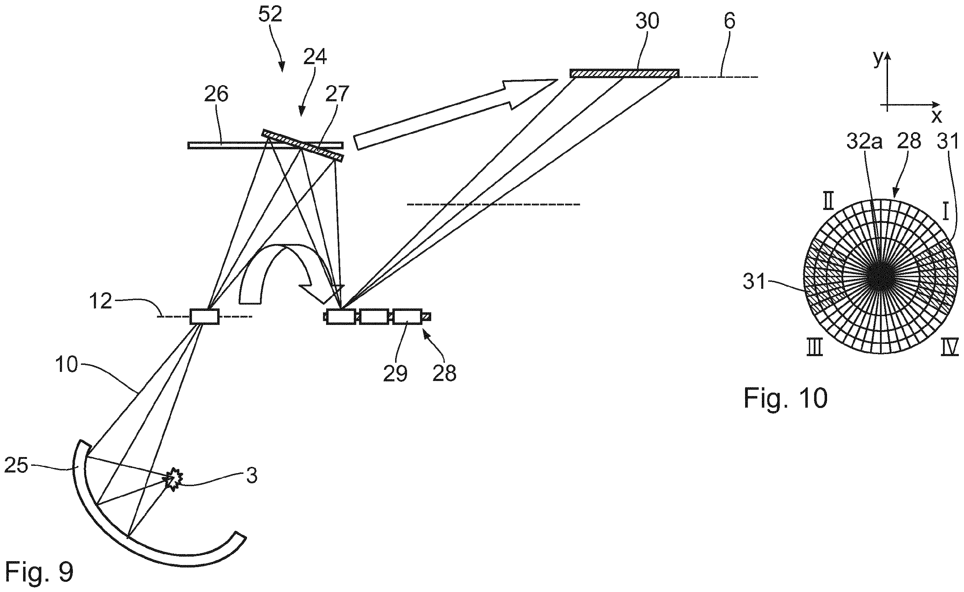

Fig. 9 zeigt schematisch die Verhältnisse bei der Beleuchtungsoptik 24, soweit dort ein Dipolsetting eingestellt ist.

Fig. 10 zeigt die zu diesem Dipol-Beleuchtungssetting gehörende Ausleuchtung des Pupillenfacettenspiegels 28. Beleuchtet werden zwei Ringsektoren am Übergang zwischen dem zweiten und dritten und am Übergang zwischen dem ersten und vierten Quadranten des Pupillenfacettenspiegels 28. Beleuchtet werden dabei Pupillenfacetten 29 der drei äußersten Pupillenfacettenringe in zwei zusammenhängenden Ringsektorbereichen 31 mit einer Umfangserstreckung um ein Zentrum 32a des Pupillenfacettenspiegels 28 von jeweils etwa 55°.

Diese Dipol-Beleuchtung des Pupillenfacettenspiegels 28 wird wiederum durch entsprechende aktuatorische Verkippung der Einzelspiegel 27 des Feldfacettenspiegels 26 erreicht, wie in der Fig. 9 am Beispiel eines der Einzelspiegel 27 beispielhaft angedeutet.

Zum Umstellen der Beleuchtungssettings entsprechend den Fig. 5, 7 und 9 ist ein Kippwinkel der Einzelspiegel 27 im Bereich von ± 50 mrad erforderlich. Die jeweilige Kippposition für das einzustellende Beleuchtungssetting muss mit einer Genauigkeit von 0,2 mrad eingehalten werden. Allgemein können die Einzelspiegel 27 um einen Kippwinkel von bis zu ± 200 mrad verkippbar sein.

Die Einzelspiegel 27 des Feldfacettenspiegels 26 bzw. die entsprechend aufgebauten Einzelspiegel 27 des Feldfacettenspiegels 13 und des Pupillenfacettenspiegels 14 bei der Beleuchtungsoptik 4 nach Fig. 1 tragen Multilayer-Beschichtungen zur Optimierung ihrer Reflektivität bei der Wellenlänge der Nutzstrahlung 10. Die Temperatur der Multilayer-Beschichtungen sollte 425 K beim Betreiben der Projektionsbelichtungsanlage 1 nicht überschreiten.

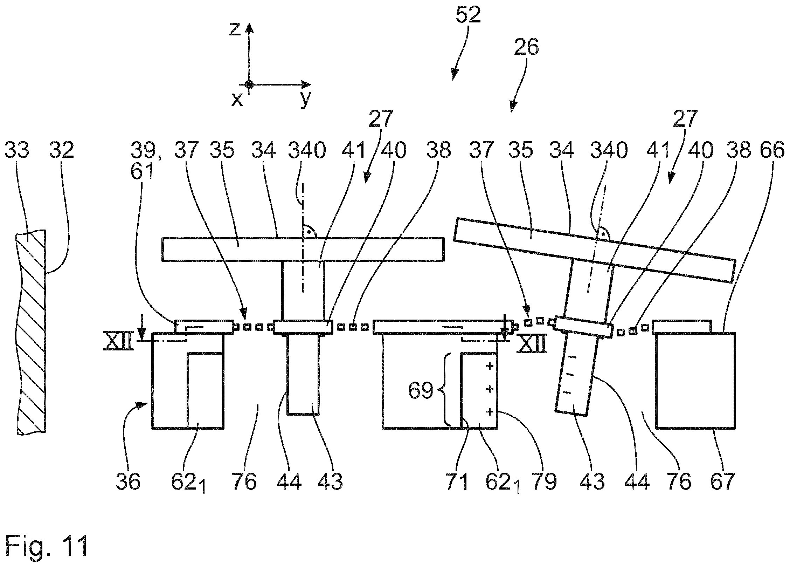

Dies wird durch einen Aufbau der Einzelspiegel 27 erreicht, der (vgl. Fig. 11) nachfolgend beispielhaft anhand eines der Einzelspiegel 27 des Feldfacettenspiegels 26 erläutert wird.

In ausgewählten der nachfolgenden Figuren ist ein lokales kartesisches Koordinatensystem eingezeichnet, wobei die xy-Ebene parallel zur Reflexionsfläche 34 in einer nicht verkippten Mittelstellung des Spiegel-Elements 27 verläuft, und die z-Richtung senkrecht hierzu, parallel zu einer zentralen Flächennormalen 340 ist. Die Einzelspiegel 27 der Beleuchtungsoptik 4 bzw. 24 sind in einer evakuierbaren Kammer 32 untergebracht, von der in den Fig. 5 und 11 eine Begrenzungswand 33 angedeutet ist.

Die Kammer 32 kommuniziert über eine Fluidleitung 33a, in der ein Absperrventil 33b untergebracht ist, mit einer Vakuumpumpe 33c. Der Betriebsdruck in der evakuierbaren Kammer 32 beträgt einige Pa (Partialdruck H₂). Alle anderen Partialdrücke liegen deutlich unterhalb von 10⁻⁵ Pa.

Der die Mehrzahl von Einzelspiegeln 27 aufweisende Feldfacettenspiegel 26 bildet allgemein ein optisches Bauelement 52 zur Führung eines Bündels der Beleuchtungsstrahlung 10. Das optische Bauelement 52 kann außerdem die evakuierbare Kammer 32 umfassen.

Jeder der Einzelspiegel 27 kann eine beaufschlagbare Reflexionsfläche 34 mit Abmessungen von 0,5 mm x 0,5 mm oder auch von 5 mm x 5 mm und größer aufweisen. Allgemein weist die Reflexionsfläche 34 lineare Abmessungen im Bereich von wenigen µm bis einigen mm auf. Bei den Einzelspiegeln 27 handelt es sich insbesondere um Mikrospiegel. Die linearen Abmessungen der Reflexionsfläche 34 liegen insbesondere im Bereich von 10 µm bis 10 mm. Die Reflexionsfläche 34 ist Teil eines Spiegelkörpers 35 des Einzelspiegels 27. Der Spiegelkörper 35 trägt die Mehrlagen-(Multilayer)-Beschichtung.

Die Reflexionsfläche 34 ist plan ausgebildet. Sie weist eine zentrale Flächennormale 340 auf. Die Reflexionsfläche 34 kann auch gekrümmt, insbesondere konvex oder konkav, ausgebildet sein. In diesem Fall sei unter der Flächennormalen 340 der Reflexionsfläche 34 die Normale zur Reflexionsfläche 34 im Bereich ihres geometrischen Schwerpunkts verstanden.

Die Reflexionsflächen 34 der Einzelspiegel 27 ergänzen sich zu einer gesamten Spiegel-Reflexionsfläche des Feldfacettenspiegels 26. Entsprechend können sich die Reflexionsflächen 34 auch zur gesamten Spiegel-Reflexionsfläche des Feldfacettenspiegels 13 oder des Pupillenfacettenspiegels 14 ergänzen.

Der Einzelspiegel 27 umfasst jeweils den Spiegelkörper 35 mit der Reflexionsfläche 34 sowie einen Aktuatorstift 43, welcher über einen Abstandshalter 41 mit dem Spiegelkörper 35 mechanisch verbunden ist. Auf dem Abstandshalter 41 ist ein zentraler Haltekörper 40 angeordnet.

Eine aus einem Substrat gebildete Tragestruktur 36 ist über einen Wärmeleitungsabschnitt 37 mit dem Einzelspiegel 27 mechanisch verbunden (vgl. Fig. 11). Teil des Wärmeleitungsabschnitts 37 ist ein Aufhängungselement 38, das eine Verkippung des Spiegelkörpers 35 relativ zur Tragestruktur 36 zulässt. Das Aufhängungselement 38 lässt eine Verkippung um mindestens eine quer zur Flächennormalen 340 orientierte Kippachse zu. Das Aufhängungselement 38 lässt außerdem eine lineare Verlagerung des Einzelspiegels 27 in Richtung der Flächennormalen 340 zu. Das Aufhängungselement 38 hat einen äußeren Haltering 39, der an der Tragestruktur 36 festgelegt ist. Weiterhin umfasst das Aufhängungselement 38 den gelenkig mit dem Haltering 39 verbundenen inneren Haltekörper 40. Dieser ist zentral unter der Reflexionsfläche 34 angeordnet. Zwischen dem zentralen Haltekörper 40 und dem Spiegelkörper 35 ist der Abstandshalter 41 angeordnet.

Für Details der Wärmeleitung vom Spiegelkörper 35 zur Tragestruktur 36 sowie für alternative Wärmeleitungsstreifen für den Wärmeleitungsabschnitt 37 und Details der thermischen Ankopplung des Abstandshalters 41 an den zentralen Haltekörper 40 sei auf die WO 2010/049076 A2 verwiesen.

Die Tragestruktur 36 ist als den Aktuatorstift 43 umgebende Hülse ausgestaltet. Die Tragestruktur 36 kann beispielsweise aus einem Silizium-Wafer hergestellt sein. Auf der Tragestruktur 36 ist das Array von Einzelspiegeln 27 nach Art der in der Fig. 11 gezeigten Einzelspiegel 27 angeordnet.

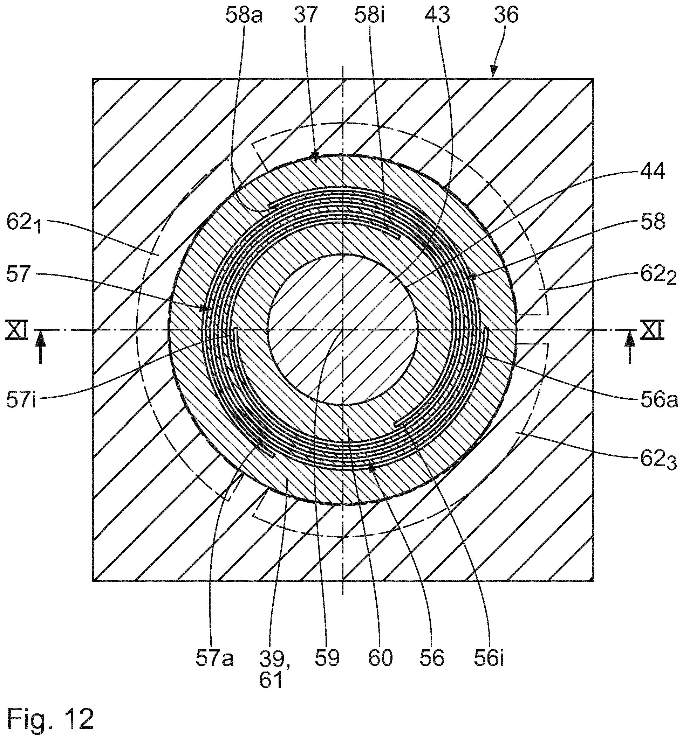

Im Folgenden werden Details des Wärmeleitungsabschnitts 37, insbesondere des Aufhängungselements 38 beschrieben. Bei dem in den Fig. 11 und 12 dargestellten Vergleichsbeispiel ist der Wärmeleitungsabschnitt 37 aus insgesamt drei spiralförmig ausgeführten Wärmeleitungsstreifen 56, 57 und 58 zusammengesetzt und stellt eine geschlitzte Membran dar. Der nähere Aufbau der nach Art dreier ineinander verschachtelter Spiralfedern angeordneten Wärmeleitungsstreifen 56 bis 58 ergibt sich aus der Schnittdarstellung der Fig. 12. Die Wärmeleitungsstreifen 56 bis 58 sind radial um ein Zentrum 59 des Einzelspiegels 27 herumführend ausgeführt. In Bezug auf das Zentrum 59 an einem radial inneren Verbindungsabschnitt 60 des Wärmeleitungsabschnitts 37 nach den Fig. 11 und 12 ist ein Verbindungsübergang 56i, 57i, 58i jeweils des Wärmeleitungsstreifens 56, 57, 58 mit dem Spiegelkörper 35 angeordnet. Der radial innere Verbindungsabschnitt 60 des Wärmeleitungsabschnitts 37 stellt gleichzeitig den Haltekörper 40 dar. Die Verbindung des jeweiligen Wärmeleitungsstreifens 56 bis 58 mit dem Spiegelkörper 35 geschieht über den Verbindungsübergang 56i, 57i, 58i, den zentralen Haltekörper 40 und den Abstandshalter 41.

An einem radial äußeren Verbindungsabschnitt 61 ist ein Verbindungsübergang 56a, 57a, 58a des jeweiligen Wärmeleitungsstreifens 56, 57, 58 mit der Tragestruktur 36 angeordnet. Die Verbindung der Wärmeleitungsstreifen 56 bis 58 mit der Tragestruktur 36 erfolgt über die Verbindungsübergänge 56a, 57a, 58a, den äußeren Verbindungsabschnitt 61, der gleichzeitig den Haltering 39 darstellt, und die Hülse der Tragestruktur 36.

Die Wärmeleitungsstreifen 56 bis 58 verlaufen voneinander über Zwischenräume getrennt. Jeder der Wärmeleitungsstreifen 56 bis 58 verbindet unabhängig von den anderen Wärmeleitungsstreifen den Spiegelkörper 35 mit der Tragestruktur 36. Die Tragestruktur 36 kann, wie in der Fig. 12 angedeutet, nach außen hin rechteckig begrenzt sein.

Die Wärmeleitungsstreifen 56 bis 58 sind so angeordnet, dass sie auf einem Radius zwischen dem inneren Verbindungsabschnitt 60 und dem äußeren Verbindungsabschnitt 61 aufeinander folgen, wobei zwischen benachbarten der Wärmeleitungsstreifen 56 bis 58 jeweils ein Zwischenraum vorliegt. Zwischen dem in der Fig. 12 in Bezug auf das Zentrum 59 in Drei-Uhr-Position angeordneten äußeren Verbindungsabschnitt 56a und dem in der Fig. 12 etwa in Fünf-Uhr-Position angeordneten inneren Verbindungsabschnitt 56i verläuft der Wärmeleitungsstreifen 56 in Umfangsrichtung um das Zentrum 59 um etwa 420°. Der Wärmeleitungsstreifen 57 verläuft zwischen dem äußeren Verbindungsübergang 57a und dem inneren Verbindungsübergang 57i zwischen der Sieben-Uhr-Position und der Neun-Uhr-Position in der Fig. 12 ebenfalls in Umfangsrichtung im Uhrzeigersinn um etwa 420°. Der Wärmeleitungsstreifen 58 verläuft zwischen dem äußeren Verbindungsübergang 58a und dem inneren Verbindungsübergang 58i zwischen der Elf-Uhr-Position und der Ein-Uhr-Position in der Fig. 12 ebenfalls in Umfangsrichtung um etwa 420°. Der Abstandshalter 41, der Aktuatorstift 43 sowie der Wärmeleitungsabschnitt 37 mit den Wärmeleitungsstreifen 56 bis 58, dem inneren Verbindungsabschnitt 60 und dem äußeren Verbindungsabschnitt 61 sind zusammen mit dem Spiegelkörper 35 aus monokristallinem Silizium gefertigt. Alternativ können die Wärmeleitungsstreifen 56 bis 58 inklusive der Verbindungsabschnitte 60, 61 auch aus polykristallinem Silizium mittels Mikrofabrikation gefertigt sein.

In der Hülse der Tragestruktur 36 sind insgesamt drei Elektroden 62₁, 62₂, 62₃ integriert, die in Umfangsrichtung um das Zentrum 59, jeweils etwa knapp 120° überstreckend, gegeneinander elektrisch isoliert angeordnet sind. Die Elektroden 62i stellen Gegenelektroden zur zentralen Elektrode 44 auf dem als Elektrodenstift ausgebildeten Aktuatorstift 43 dar. Die äußeren Elektroden 62i und die zentrale Elektrode 44 sind Bestandteil eines Aktuators 50 zur Verlagerung des Spiegelelements 27. Die zentrale Elektrode 44 ist über den Abstandshalter 41 mit dem Spiegelkörper 35 des Spiegel-elements 27 verbunden. Der Aktuatorstift 43 kann als Hohlzylinder ausgeführt sein. Bei einer weiteren Ausführungsform des Einzelspiegels 27 können auch vier oder mehr Elektroden 62i anstelle der drei Elektroden 62₁, 62₂, 62₃ vorhanden sein. Allgemein sind in der Tragestruktur 36 mindestens zwei Elektroden 62ᵢ integriert. Es können auch vier oder mehr Elektroden 62i in der Hülse der Tragestruktur 36 integriert sein, d. h. mit der Tragestruktur 36 verbunden sein. Die Elektroden 62ᵢ sind insbesondere gleichmäßig um das Zentrum 59 herum angeordnet. Die Elektroden sind vorzugsweise gleichmäßig über den Umfang der Hülse verteilt angeordnet.

In der Fig. 11 rechts ist der Einzelspiegel 27 in einer gekippten Stellung gezeigt, in der die Gegenelektrode 62₁ auf einem positiven Potenzial V+ relativ zu einem negativen Potenzial V- der Elektrode 44 des Aktuatorstifts 43 geschaltet ist. Aufgrund dieser Potenzialdifferenz, V₊ minus V₋, ergibt sich eine Kraft F_{E}, die das freie Ende des Aktuatorstifts 43 hin zur Gegenelektrode 64 zieht, was zu einer entsprechenden Verkippung des Einzelspiegels 27 führt. Die federnde Membranaufhängung aus den drei Wärmeleitungsstreifen 56, 57, 58 sorgt dabei für eine nachgiebige und kontrollierte Verkippung des Einzelspiegels 27. Zudem sorgt diese federnde Membranaufhängung für eine hohe Steifigkeit des Einzelspiegels 27 gegenüber translatorischen Bewegungen in der Membranebene der federnden Membranaufhängung, das heißt insbesondere in Richtung senkrecht zur Flächennormalen 340, was auch als hohe in-plane-Steifigkeit bezeichnet ist. Diese hohe Steifigkeit gegenüber translatorischen Bewegungen in der Membranebene unterdrückt eine unerwünschte translatorische Bewegung des Aktuatorstifts 43, also des Elektrodenstifts, in Richtung hin zu den Elektroden 62i ganz oder weitgehend. Auf diese Weise ist eine unerwünschte Reduzierung eines möglichen Kippwinkelbereichs des Aktuatorstifts 43 und damit des Spiegelkörpers 35 vermieden.

Je nachdem, wie das relative Potenzial der Gegenelektroden 62ᵢ zum Potenzial der Elektrode des Aktuatorstifts 43 gewählt ist, können die Einzelspiegel 27 um einen vorgegebenen Kippwinkel verkippt werden. Dabei sind nicht nur Kippwinkel möglich, die einer Neigung des Aktuatorstifts 43 genau zu einer der drei Gegenelektroden 62ᵢ hin entsprechen, sondern, je nach einer vorgegebenen Potenzialkombination der Gegenelektroden 62ᵢ, auch beliebige andere Kippwinkel-Orientierungen.

Anstelle eines Aktuatorstifts 43 mit rundem Querschnitt kann auch ein Aktuatorstift mit elliptischem Querschnitt gewählt werden. Die Halbachsen der Ellipse dieses Querschnitts sind dann so gewählt, dass ein Abstand zwischen der Elektrode des Aktuatorstifts und den Gegenelektroden 62ᵢ entlang einer ersten Achse, in der ein größerer Kippwinkelbereich gewünscht ist, geringer ist als entlang einer zweiten, hierzu senkrechten zweiten Achse, längs der ein kleinerer Kippwinkelbereich gewünscht ist. Der größere Kippwinkelbereich kann 100 mrad oder 200 mrad und der kleinere Kippwinkelbereich kann 50 mrad betragen.

Bei dem in Fig. 11 dargestellten Vergleichsbeispiel sind die in die Tragestruktur 36 integrierten, das heißt mit dieser verbundenen Elektroden 62₁, 62₂, 62₃ in z-Richtung gegen die mit dem Aktuatorstift 43 verbundene zentrale Elektrode 44 versetzt angeordnet. Dies führt dazu, dass bei Anlegen einer elektrischen Spannung zwischen den äußeren Elektroden 62₁, 62₂, 62₃ und der zentralen Elektrode 44 ein elektrisches Feld erzeugbar ist, welches im Bereich der zentralen Elektrode 44 einen Gradienten in z-Richtung der aufweist. Allgemein ist es möglich, ein elektrisches Feld zu erzeugen, welches eine über die Erstreckung der zentralen Elektrode 44 in z-Richtung variierende Feldstärke aufweist. Das elektrische Feld weist insbesondere eine derartige Verteilung der Feldstärke auf, das die über die Erstreckung der zentralen Elektrode 44 gemittelte Feldstärke eine Komponente in z-Richtung aufweist. Die gemittelte Feldstärke kann hierbei mithilfe eines Flächenintegrals des Feldstärken-Vektorfeldes über die Erstreckung der zentralen Elektrode 44 bestimmt werden. Ein derartiges Feld führt zu einer Kraft mit einer Komponente in z-Richtung, welche auf die zentrale Elektrode 44 und damit auf das Spiegelelement 27 wirkt. Aufgrund der flexiblen Ausbildung des Aufhängungselements 38 ist das Spiegelelement 27 somit durch Anlegen einer geeigneten Spannung an die äußeren Elektroden 62₁, 62₂, 62₃ und die zentrale Elektrode 44 linear in z-Richtung verlagerbar. Durch geeignete Ansteuerung der äußeren Elektroden 62₁, 62₂, 62₃ kann das Spiegelelement 27 unabhängig von einer Verkippung in z-Richtung verlagert werden. In einer vorteilhaften Weiterbildung kann die Ansteuerung der Elektroden 62₁, 62₂, 62₃ und 44 Bestandteil einer Regeleinrichtung sein, welche außerdem mindestens einen, insbesondere mindestens mehrere Sensoren zur Erfassung der Position des Spiegelelements 27, insbesondere dessen Position in z-Richtung und/oder dessen Kippstellung, aufweist.

Die äußeren Elektroden 62₁, 62₂, 62₃ können alle dieselbe Länge in z-Richtung aufweisen. Sie können insbesondere auch dieselbe Länge wie die zentrale Elektrode 44 aufweisen, aber versetzt angeordnet sein.

Eine unerwünschte Verkippung des Spiegelelements 27 bei Anlegen einer Spannung an eine der Elektroden 62₁, 62₂, 62₃ in Bezug auf die zentrale Elektrode 44 kann durch Anlegen einer geeigneten Ausgleichsspannung an eine oder mehrere der übrigen äußeren Elektroden 62₁, 62₂, 62₃ erreicht werden. Die Amplitude und Verteilung der an die übrigen Elektroden 62₁, 62₂, 62₃ anzulegende Ausgleichsspannung hängt von der Anzahl der äußeren Elektroden und deren Verteilung über die Tragestruktur 36 und um den Aktuatorstift 43 ab.

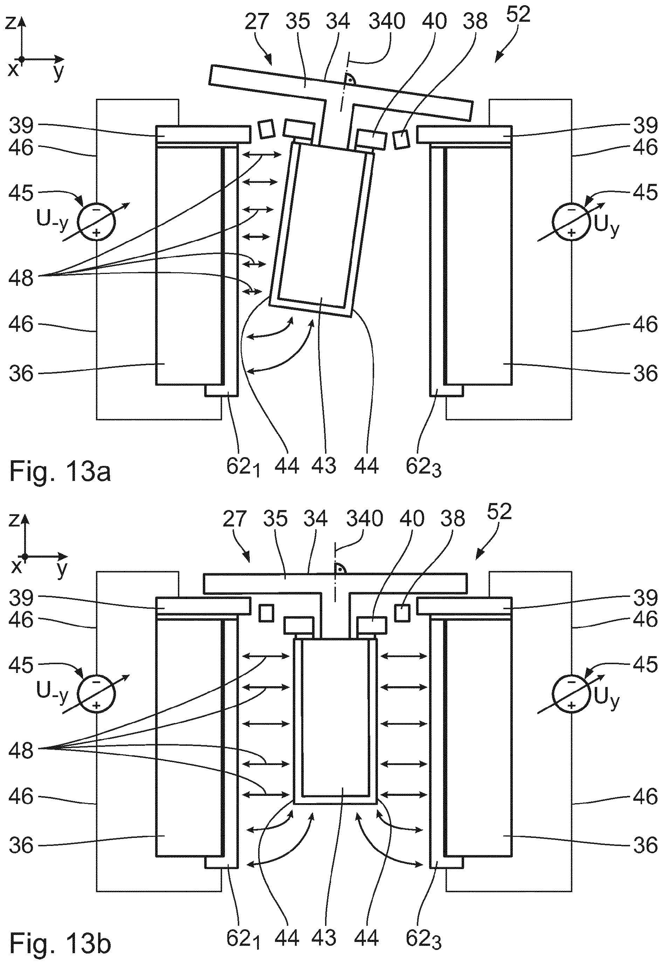

In den Fig. 13a und 13b ist eine weiteres Vergleichsbeispiel dargestellt, bei welcher die Spiegelelemente 27 relativ zur Tragestruktur 36 in z-Richtung linear verlagerbar und um eine quer zur Flächennormalen 340 orientierte Kippachse verkippbar sind. Bei diesem Vergleichsbeispiel sind vier äußere Elektroden 62ᵢ in die Tragestruktur 36 integiert, von welchen in der Schnittdarstellung zwei einander gegenüberliegende Elektroden 62₁ und 62₃ dargestellt sind. Außerdem sind in den Figuren schematisch Spannungsquellen 45 und Zuleitungen 46 derselben zu den Elektroden 44, 62₁ und 62₃ dargestellt. Die Spannungsquellen 45 und die Zuleitungen 46 sind nur schematisch dargestellt. Sie sind in die Tragestruktur 36 integriert und mittels einer in den Figuren 13a und 13b nicht dargestellten Steuereinrichtung 153 in signalübertragender Weise verbunden.

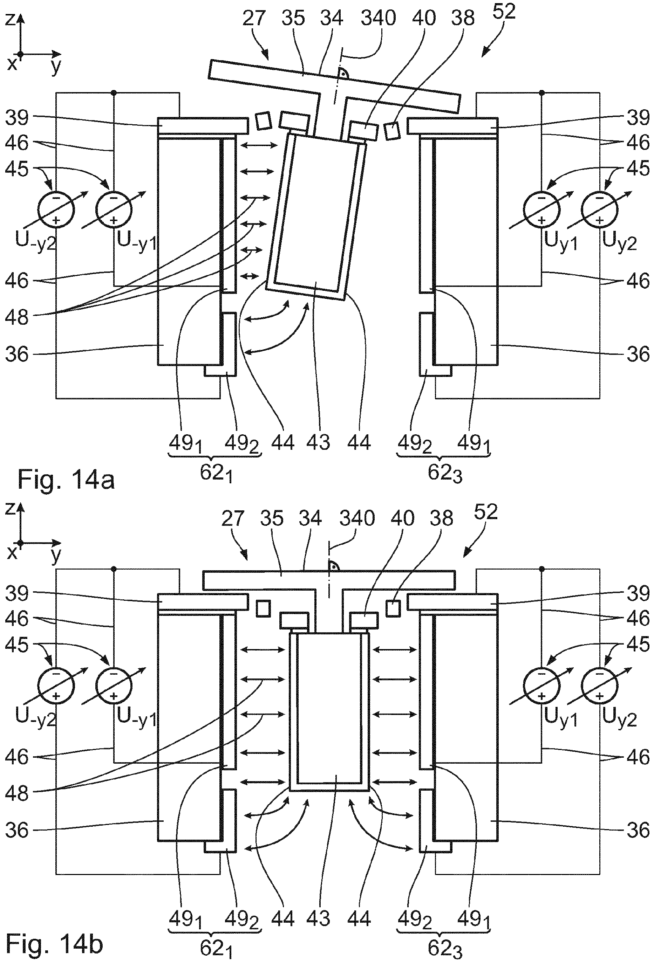

Bei diesem Vergleichsbeispiel ist die zentrale Elektrode 44 kürzer ausgebildet ist als die äußeren Elektroden 62ᵢ. Hierdurch wird wiederum erreicht, dass sich durch Anlegen einer Spannung ein elektrisches Feld erzeugen lässt, dessen Feldlinien 48 in den Figuren schematisch angedeutet sind, welches eine über die Erstreckung der zentralen Elektrode 44 in z-Richtung variierende Feldstärke aufweist. Hierdurch lässt sich wiederum eine Kraft mit einer Komponente in z-Richtung auf die zentrale Elektrode 44 und somit über den Aktuatorstift 43 auf das Spiegelelement 27 ausüben. In den Fig. 14a und 14b ist eine weitere Ausführungsform des Aktuators 52 dargestellt. Bei dieser Ausführungsform sind die äußeren Elektroden 62ᵢ zweiteilig ausgebildet. Sie weisen mit anderen Worten jeweils zwei separate Teilelektroden 49ᵢ auf. Die Teilelektrode 49₁ und 49₂ sind jeweils in z-Richtung gegeneinander versetzt angeordnet. Sie sind insbesondere in z-Richtung hintereinander angeordnet. Sie sind unabhängig voneinander mit Spannung U_{y1}, U_{y2}, U_{-y1}, U_{-y2} beaufschlagbar. Die äußeren Elektroden 62ᵢ können auch jeweils mehr als zwei Teilelektroden 49ᵢ umfassen.

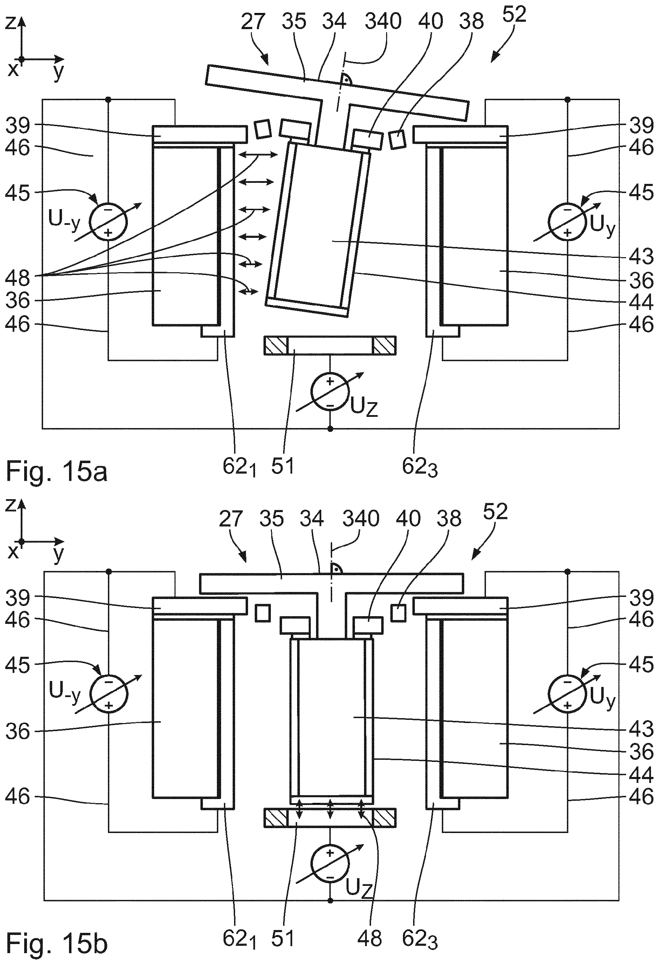

In den Fig. 15a und 15b ist ein weiteres Ausführungsbeispiel des Aktuators 52 dargestellt. Bei diesem Ausführungsbeispiel ist die separate Teilelektrode 51 quer, insbesondere senkrecht zur z-Richtung ausgerichtet. Mit einer derartigen, senkrecht zur z-Richtung ausgerichteten äußeren Teilelektrode 51 lässt sich besonders vorteilhaft eine lineare Verlagerung des Spiegel-elements 27 unabhängig von einer Verkippung desselben steuern.

Der Einzelspiegel 27 ist also mittels des Aktuators 52 in Form eines elektromagnetisch arbeitenden Aktuators verlagerbar. Ein derartiger Aktuator 52 lässt sich in einem Batch-Prozess als mikroelektromechanisches System (micro-electro-mechanical system, MEMS) herstellen. Mit einem derartigen Aktuator 52 lässt sich eine Kraftdichte von 20 kPa erreichen. Die Kraftdichte ist definiert als das Verhältnis aus der Aktuatorkraft zu derjenigen Fläche des Aktuators 52, über die die Aktuatorkraft wirkt. Als Maß für die an sich zu betrachtende Seitenfläche des Aktuators 52, über die die Aktuatorkraft wirkt, kann der Querschnitt des Aktuatorstifts 43 dienen. Die mittels des Aktuators 52 bewirkbare Verlagerung der Einzelspiegel 27 hängt einerseits von der mittels des Aktuators 52 erzeugbaren Kraft auf die Einzelspiegel 27 sowie andererseits von den Details deren Lagerung, insbesondere des Aufhängungselements 38, ab.

Für weitere Arten des Aufhängungselements 38 und deren Details sei auf die WO 2010//049076 A2 verwiesen.

Eine Summe der Reflexionsflächen 34 auf den Spiegelkörpern 35 ist größer als das 0,5-fache einer von der Gesamt-Reflexionsfläche des Feldfacettenspiegels 26 belegten Gesamtfläche. Die Gesamtfläche ist dabei definiert als die Summe der Reflexionsflächen 34 zuzüglich der Flächenbelegung durch die Zwischenräume zwischen den Reflexionsflächen 34. Ein Verhältnis der Summe der Reflexionsflächen der Spiegelkörper einerseits zu dieser Gesamtfläche wird auch als Integrationsdichte bezeichnet. Diese Integrationsdichte kann auch größer sein als 0,7, insbesondere größer als 0,9.

Mit Hilfe der Projektionsbelichtungsanlage 1 wird wenigstens ein Teil des Retikels 30 auf einen Bereich einer lichtempfindlichen Schicht auf dem Wafer zur lithografischen Herstellung eines mikro- bzw. nanostrukturierten Bauelements, insbesondere eines Halbleiterbauelements, z.B. eines Mikrochips abgebildet. Je nach Ausführung der Projektionsbelichtungsanlage 1 als Scanner oder als Stepper werden das Retikel 30 und der Wafer zeitlich synchronisiert in der y-Richtung kontinuierlich im Scannerbetrieb oder schrittweise im Stepperbetrieb verfahren.

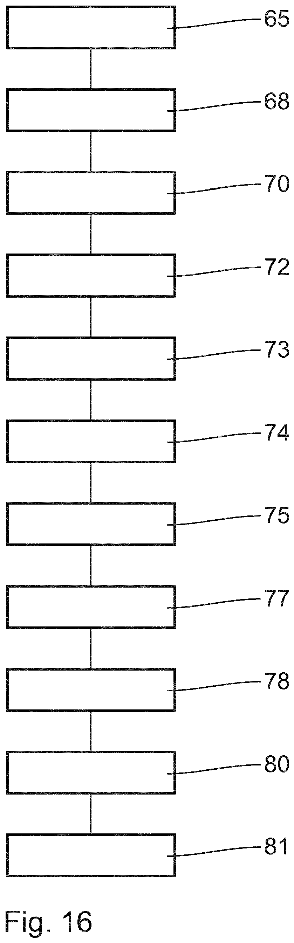

Nachfolgend wird ein Verfahren zur Herstellung des Aktuators 50, insbesondere der Elektroden 44 und 62ᵢ erläutert. Die einzelnen Verfahrensschritte sind schematisch in der Fig. 16 dargestellt.

In einem Bereitstellungsschritt 65 wird ein Ausgangssubstrat bereitgestellt. Hierbei handelt es sich um einen monokristallinen Silizium-Wafer, dessen Dicke vorzugsweise zwischen 300 µm und 750 µm liegt. Die Dicke des Silizium-Wafers kann auch unterhalb oder oberhalb dieses Bereichs liegen. Als Vorderseite 66 (vgl. Fig. 11) des Ausgangssubstrats wird nachfolgend die Seite bezeichnet, an der später der Wärmeleitungsabschnitt 37 angebracht wird. Die Gegenelektroden 62ᵢ werden von einer der Vorderseite 66 gegenüberliegenden Substratrückseite 67 des Ausgangssubstrats her strukturiert.

In einem Ätzschritt 68 wird nun eine Basisstruktur von der Substratrückseite 67 in das Ausgangssubstrat, also in ein die spätere Tragestruktur 36 ergebendes Roh-Trägersubstrat geätzt. Es kann sich hierbei um die ring- oder hülsenförmige Tragestruktur 36 handeln. Die im Ätzschritt 68 geätzte Tragestruktur 36 ist an Trennstellen zwischen den Gegenelektroden 62ᵢ unterbrochen. Der Ätzschritt 68 erfolgt mit Hilfe eines Standardverfahrens wie optischer Lithografie und Siliziumtiefenätzen (deep reactive ion etching, DRIE). Mit dem Ätzschritt 68 wird die Form der Gegenelektroden 62ᵢ definiert und ein Negativ nach Art einer Gussform für die später zu schaffenden Gegenelektroden 62ᵢ geätzt. Eine Ätztiefe 69 definiert die Höhe der Gegenelektroden 62ᵢ. Diese Ätztiefe 69 kann geringer sein als die Dicke des Ausgangssubstrats. Bei einer nicht dargestellten Ausführung kann die Ätztiefe auch genauso groß sein wie die Dicke des Ausgangssubstrats.

In einem Aufbringungsschritt 70 wird nun in Gussformen 71, die im Ätzschritt 68 geätzt wurden, zur elektrischen Isolierung der späteren Gegenelektroden 62ᵢ auf das Ausgangssubstrat eine dielektrische Schicht aufgebracht. Bei der dielektrischen Schicht kann es sich um Siliziumdioxid handeln. Die Aufbringung kann mittels eines Standardverfahrens wie thermischer Oxidation oder CVD (Chemical Vapor Deposition) geschehen. Die Dicke der dielektrischen Schicht beträgt mehrere Mikrometer. Die dielektrische Schicht kann als Schicht aus dotiertem Siliziumoxid ausgeführt sein, wodurch eine Vorbereitung für eine spätere Dotierung der Gegenelektroden 62ᵢ geschehen kann.

In einem Auffüllschritt 72 wird die mit der dielektrischen Schicht ausgekleidete Gussform 71 mit polykristallinem Silizium aufgefüllt. Hierbei kann ein LPCVD-(Low Pressure, Niederdruck, CVD)Verfahren zum Einsatz kommen. Das polykristalline Silizium ist dotiert und elektrisch leitfähig. Eine Dotierung des polykristallinen Siliziums kann direkt während des Auftragens oder nachträglich mittels Diffusion geschehen.

In einem Polierschritt 73, der durch ein CMP-(Chemical-Mechanical Polishing, chemisch-mechanisches Polieren)Verfahren realisiert sein kann, wird überschüssiges polykristallines Silizium, das während des Auffüllschritts 72 außerhalb der Gussformen 71 auf dem Aufgangssubstrat aufgewachsen ist, wegpoliert.

In einem Strukturierschritt 74 wird nun auf der Vorderseite 66 des Ausgangssubstrats der Wärmeleitungsabschnitt 37 auf das Ausgangssubstrat aufgebracht. Dies kann mit Hilfe eines Dünnschichtverfahrens realisiert werden. Wie vorstehend erläutert, verbindet der Wärmeleitungsabschnitt 37 den Aktuatorstift 43, also die zentrale Elektrode 44, mit der Tragestruktur 36. Als Dünnschicht kann eine polykristalline Diamantschicht zum Einsatz kommen. Die polykristalline Diamantschicht kann mit Hilfe eines CVD-Verfahrens, insbesondere eines Niederdruck-CVD-Verfahrens, aufgebracht werden. Der Strukturierschritt 74 ist für das Gegenelektroden-Herstellungsverfahren nicht zwingend, sondern dient der Vorbereitung der Anbringung der beweglichen zentralen Elektrode.

In einem Anbringungsschritt 75 wird der Spiegelkörper 35 von der Vorderseite 66 her angebracht. Dies geschieht derart, dass die jeweiligen Spiegelkörper 35 nach ihrer Vereinzelung jeweils im zentralen Bereich, also im Bereich des späteren zentralen Abstandshalters 41 mit dem Ausgangssubstrat verbunden sind. Der Anbringungsschritt 75 kann als Fusionsbond-Prozess gestaltet sein.

In einem weiteren Strukturierschritt 77 wird von der Rückseite 67 des Ausgangssubstrats her mit Hilfe optischer Lithografie und Tiefenätzverfahren die zentrale und vorzugsweise bewegliche Elektrode, also der Aktuatorstift 43, strukturiert. Dies geschieht durch Freiätzen eines Zwischenraums 76 zwischen dem Aktuatorstift 43, insbesondere der zentralen Elektrode 44, und der Hülse der Tragestruktur 36. Hierbei wird das Ausgangssubstrat komplett durchgeätzt. Die zentrale Elektrode 44 ist anschließend nur noch über den Wärmeleitungsabschnitt 37, also über die vorher auf der Vorderseite 66 angebrachte Federaufhängung mit dem Ausgangssubstrat verbunden. Die Oxidschicht, die im Aufbringungsschritt 70 aufgebracht wurde, wirkt während dieses weiteren Strukturierschritts 77 als seitlicher Ätzstopp und schützt die im Auffüllschritt 72 für die Gegenelektroden 62ᵢ vorbereiteten Elemente aus polykristallinem Silizium.

Erfindungsgemäß ist vorgesehen, im Strukturierschritt 77 den Aktuatorstift 43, insbesondere die zentrale Elektrode 44 zu verkürzen. Sie kann hierzu von der Rückseite 67 des Ausgangssubstrats her weggeätzt werden.

In einem Freilegungsschritt 78 wird nun die freigelegte Oxidschicht auf einer Innenseite 79 der Gegenelektroden 62ᵢ weggeätzt. Dieser Freilegungsschritt 78 kann auch weggelassen werden.

Der so vorbereitete Mikrospiegelaktuator kann in einem Anbindungsschritt 80 elektrisch und mechanisch an ein weiteres Substrat angebunden werden. Dies kann über ein Flip-Chip-Verfahren geschehen, über das die hergestellten Elektrodenanordnungen auf einen integrierten Schaltkreis (ASIC) gebondet werden. Dies geschieht von der Substratrückseite 67 her. Hierbei werden die Gegenelektroden 62ᵢ elektrisch mit entsprechenden Schaltkreisen auf dem integrierten Schaltkreis verbunden. Eine derartige Konfiguration erlaubt eine integrierte Ansteuerung der Gegenelektroden 62ᵢ und damit eine entsprechende Kontrolle der Kippspiegel des jeweiligen Einzelspiegels 27.

Die mit diesem Verfahren hergestellten Gegenelektroden 62ᵢ sind in die Tragestruktur 36 integriert, sind insbesondere nicht mechanisch vom Ausgangssubstrat getrennt, sondern mit der Tragestruktur 36 verbunden. Die Tragestruktur 36 ist somit auch nach der Integration der Gegenelektroden 62ᵢ eine monolithische Einheit, die genügend Stabilität für weitere Prozessschritte, insbesondere für die Verbindung im Anbindungsschritt 80 gewährleistet.

Beim Anbindungsschritt 80 können die Gegenelektroden 62ᵢ von der Rückseite 67 her über das Flip-Chip-Verfahren in einem Kontaktierungsschritt 81 direkt, also von einer in der Fig. 11 vertikal und senkrecht zur Reflexionsfläche 34 in der Neutralstellung verlaufenden Richtung her, kontaktiert werden. Ein Kontaktieren von einer beispielsweise in der Fig. 11 horizontal verlaufenden Richtung her ist nicht erforderlich.

Zusammengefasst umfasst das Verfahren zur Herstellung des optischen Bauelements 52 die folgenden Schritte: Bereitstellen eines Substrats zur Herstellung der Tragestruktur 36 für die Spiegelelemente 27 und Strukturieren des Substrat mittels eines Ätzverfahrens sowie Abscheiden von Kontaktstrukturen auf dem Substrat zur Herstellung der Elektroden 44 und 62ᵢ. Erfindungsgemäß ist hierbei vorgesehen, die im fertigen Bauelement 52 als zentrale Elektroden 44 dienenden Strukturen selektiv durch ein Ätzverfahren zu verkürzen. Außerdem wird ein vorprozessierter Spiegel-Array-Waferstack bereitgestellt und mit dem Substrat zusammengefügt.

Für Details der Vorprozessierung des Spiegel-Array-Waferstacks sowie der Strukturierung des Substrats sei auf die vorhergehende Beschreibung sowie auf die WO 2010/049076 A2 und die DE 10 2011 006 100.2 verwiesen.

Für weitere Details der Herstellung des optischen Bauelements, insbesondere der Spiegelelemente 27, inbesondere Details eines Verfahrens zur Herstellung der Reflexionsfläche 34 mit extrem geringer Rauhigkeit, sei auf die WO 2010/049076 A2 verwiesen.

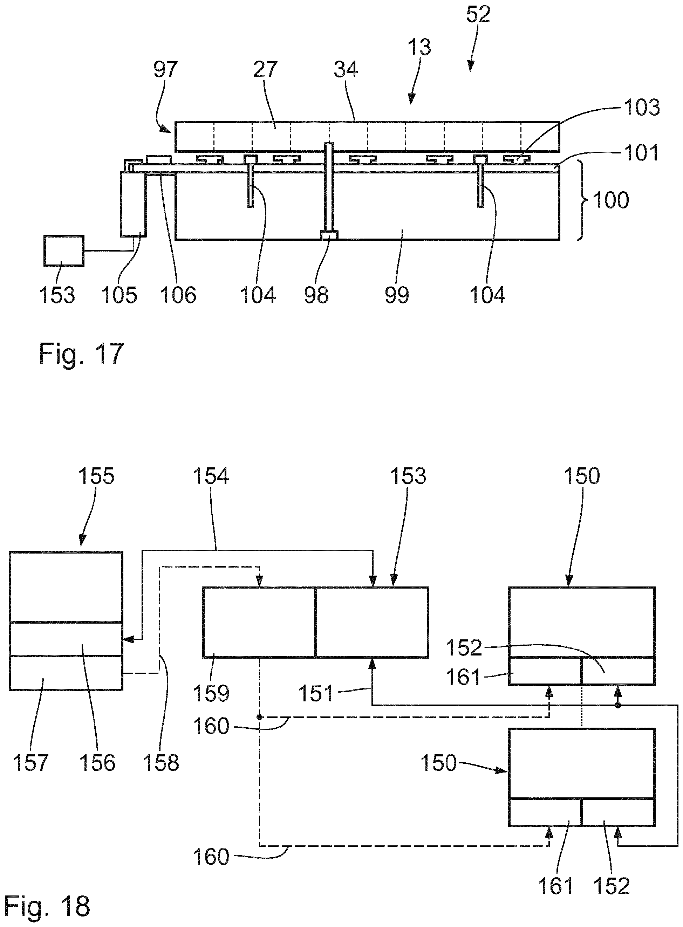

Fig. 17 zeigt am Beispiel des Feldfacettenspiegels 13 das optische Bauelement 52 mit zeilen- und spaltenweise, also nach Art eines Arrays angeordneten Einzelspiegeln 27 schematisch im Querschnitt senkrecht zu einer gesamten Spiegel-Reflexionsfläche, zu der sich die Reflexionsflächen 34 der Einzelspiegel 27 ergänzen. Komponenten und Funktionen, die denjenigen entsprechen, die vorstehend unter Bezugnahme auf die Fig. 1 bis 16 bereits erläutert wurden, tragen die gleichen Bezugsziffern und werden nicht nochmals im Einzelnen diskutiert.

Die nach Art eines Arrays angeordneten Einzelspiegel 27 sind in der Fig. 17 schematisch zu einer Spiegelplatte 97 zusammengefasst. Über wärmeleitfähige Spiegelplatten-Fixierstifte 98, von denen in der Fig. 24 lediglich einer dargestellt ist, ist die Spiegelplatte 97 an einen Keramikträger 99 fixiert, der gleichzeitig die Funktion einer Wärmesenke hat, in den also beispielsweise durch Restabsorption oder über elektrische Leistung eingebrachte Wärme von der Spiegelplatte 97 weg abgeführt wird.

Der Keramikträger 99 ist Teil einer Verlagerungs-Ansteuerplatine 100, die auf der den Reflexionsflächen 34 gegenüberliegenden Seite der Spiegelplatte 97, also der Einzelspiegel 27, angeordnet ist. Auf der Wärmesenke 99 der Ansteuerplatine 100 ist auf der der Spiegelplatte 97 zugewandten Seite zunächst eine Schicht eines Keramiksubstrats 101 aufgetragen. Das Keramiksubstrat 101 kann alternativ auch aus einem Siliziummaterial gefertigt sein. Auf dem Keramiksubstrat 101 sind integrierte elektronische Verlagerungsschaltungen (ASICs) 103 angeordnet. Jedem der verlagerbaren Einzelspiegel 27 des Feldfacettenspiegels 13 ist einer der ASICs 103 räumlich zugeordnet. Jeder ASIC 103 ist dabei einer Gruppe von Einzelspiegeln 27, nämlich jeweils genau vier Einzelspiegel 27, zugeordnet, wie nachfolgend noch beschrieben wird. Das Keramiksubstrat 101 ist an der Wärmesenke 99 über eine Mehrzahl von federnden Substrat-Fixierstiften 104 befestigt.

Über eine Anschlussklemme 105 ist die Ansteuerplatine 100 mit einer zentralen Steuereinrichtung 153 verbunden, die in der Fig. 17 nur schematisch dargestellt ist. Mit der Anschlussklemme 105 ist auch eine Masseleitung 106 der Ansteuerplatine 100 verbunden.

Fig. 18 zeigt ein Ansteuerungsschema für ein optisches Bauelement nach Art beispielsweise des Facettenspiegels 13, die in mehrere Teil-Einzelspiegelarrays aus jeweils zeilen- und spaltenweise angeordneten Einzelspiegeln 27 unterteilt ist.

Im Ansteuerschema nach Fig. 18 sind Hauptsteuerleitungen, Datenleitungen, eine Reset-Leitung und eine serielle Taktgeberleitung zu einem seriellen Datenbus 151 zusammengefasst. Über Bus-Schnittstellen 152 stehen die Teil-Einzelspiegelarrays 150 über den Datenbus 151 mit einer zentralen Steuereinrichtung 153 in Signalverbindung. Bei der zentralen Steuereinrichtung 153 kann es sich um einen Mikrocontroller oder um einen programmierbaren integrierten Schaltkreis, (Field Programmable Gate Array) oder um einen speziellen programmierbaren Logikbaustein (Programmable Logic Device, PLD) handeln. Über eine bidirektionale Signalleitung 154 steht die zentrale Steuereinrichtung 153 mit einem Zielapplikationsinterface 155 in Signalverbindung. Hierüber wird die Projektionsbelichtungsanlage 1 gesteuert und hierüber können die jeweiligen Beleuchtungssettings vorgegeben werden. Das Zielapplikationsinterface 155 hat ein Signalmodul 156 und ein Versorgungsmodul 157. Das Signalmodul 156 steht mit der Signalleitung 154 in Verbindung. Das Versorgungsmodul 157 des Zielapplikationsinterface 155 steht über eine Versorgungsleitung 158 mit einer zentralen Versorgungseinrichtung 159 in Verbindung, die in die zentrale Steuereinrichtung 153 integriert ist. Die zentrale Versorgungseinrichtung 159 steht über Versorgungsleitungen 160 mit Versorgungsschnittstellen 161 der Teil-Einzelspiegelarrays 150 in Verbindung.

Für Details der Ansteuerung des optischen Bauelements durch Vorgabe von individuellen Positionen der Einzelspiegel 27 desselben sei auf die WO 2010/049076 A2 verwiesen. Im Gegensatz zur Ansteuerung des optischen Bauelements 52 gemäß der WO 2010/049076 A2 ist vorgesehen, zusätzlich zur Verschwenkposition, d. h. dem Kippwinkel, der Einzelspiegel 27 deren lineare Position in Richtung der Flächennormalen 340 vorzugeben. Mit anderen Worten ist vorgesehen, zur Einstellung eines Beleuchtungssettings mit einer vorgegebenen Winkel- und Phasen-Verteilung zur Beleuchtung des Objektfeldes 5 jeweils den Kippwinkel und die Spiegelhöhe der Spiegelelemente 27 mittels der Steuereinrichtung 153 einzustellen.

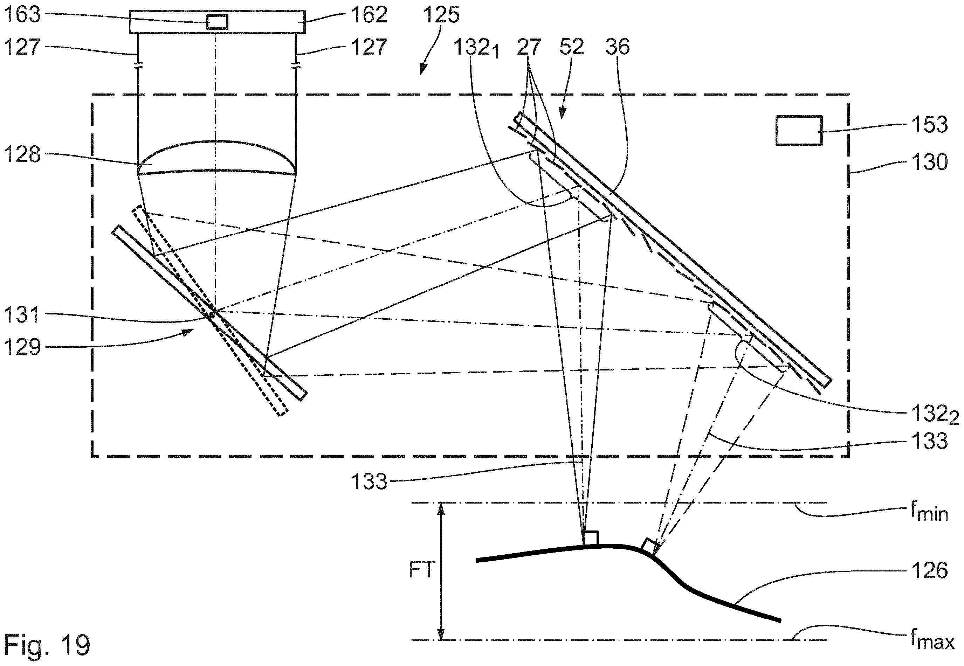

Im Folgenden werden unter Bezugnahme auf die Fig. 19 bis 22 weitere Anwendungsmöglichkeiten des optischen Bauelements 52 beschrieben. Allgemein ist das Bauelement 52 Bestandteil einer Strahlführungsoptik insbesondere für ein Vielstrahlsystem. Mittels des optischen Bauelements 52 kann eine Mehrzahl von Strahlen oder Strahlenbündeln unabhängig voneinander geführt, insbesondere unabhängig voneinander auf eine Oberfläche 126 fokussiert werden. Hierbei ist insbesondere die Fokuslänge, d. h. die Brennweite, die Lage des Fokus auf der Oberfläche 126 oder in der Probe und die Intensitätsverteilung im Bereich des Fokus jedes der Strahlen durch Verlagerung der Spiegelelemente 27 beeinflussbar. Gemäß dem in Fig. 19 dargestellten Ausführungsbeispiel ist das Bauelement 52 Bestandteil eines als Scanoptik 125 ausgebildeten optischen Systems. Hierbei handelt es sich um ein System, insbesondere ein Vielstrahlsystem, zur Bearbeitung und/oder Untersuchung einer Oberfläche 126. Bei einer Oberfläche 126 kann es sich insbesondere um eine gekrümmte Oberfläche 126 handeln. Bei dem optischen Vielstrahlsystem 125 handelt es sich insbesondere um eine Lasermaterialbearbeitungsanlage, ein System zur Lasermarkierung, ein System zur aufbauenden Herstellung von Strukturen, z.B. durch Laser-Sintern oder um ein System zur Laserbehandlung, insbesondere für medizinische Zwecke. Es kann sich auch um ein System zur dreidimensionalen Bildaufnahme, insbesondere zur dreidimensionalen Erfassung der topografischen Struktur einer Oberfläche handeln. Es kann sich auch um ein System zur dreidimensionalen Bildaufnahme mit lokalen Photoanregung handeln. Bei diesem auch als Photomanipulation bezeichneten Verfahren kann es vorteilhaft sein mit einem Vielstrahlsystem an mehrerer Stellen gleichzeitig die Probe mit Licht anzuregen. Die Bildaufnahme erfasst dann die Reaktion der Probe auf diese simultane Anregung. Eine weitere Anwendung nutzt die Einstellbarkeit des Vielstrahlsystems zur flexiblen strukturierten Beleuchtung. Hier wird ein Intensitätsgitter in der Probe erzeugt, das durch Verrechnung von Bildern mit unterschiedlichen Gitterpositionen und -orientierungen eine Auflösungserhöhung erlaubt. Eine andere Anwendung dieser Intensitätsgitter in der Probe sind ist eine quasikonfokale Verringerung der Fokustiefe in einem Weitfeldmikroskop. Auch hier werden Bilder mit unterschiedlichen Gitterpositionen miteinander verrechnet.

Andere Verwendungsmöglichkeiten sind ebenso denkbar.

Die Scanoptik 125 umfasst ein Beleuchtungssystem 162 mit einer Strahlungsquelle 163. Als Strahlungsquelle dient insbesondere ein Laser. Die Strahlungsquelle 163 kann ein- oder mehrkanalig ausgebildet sein. Das Beleuchtungssystem 162 kann weitere optische Komponenten umfassen.

Die Laserstrahlung 127 wird mittels einer Fokussierlinse 128 über einen verkippbar gelagerten Spiegel 129 zum optischen Bauelement 52 und von dort zur zu bearbeitenden Oberfläche 126 geführt. Der verkippbar gelagerte Spiegel 129 und das optische Bauelement 52 sind Bestandteile einer Strahlführungsoptik 130.

Der Spiegel 129 ist im Strahlengang zwischen der Strahlungsquelle 163 und dem optischen Bauelement 52 angeordnet.

Der Spiegel 129 ist um eine Kippachse 131 verkippbar gelagert. Die Kippachse 131 verläuft in der Fig. 19 senkrecht zur Zeichenebene, was in der Fig. 19 durch zwei alternative Stellungen des Spiegels 129 verdeutlicht ist. Der Spiegel 129 kann auch um zwei Kippachsen, insbesondere zwei senkrecht aufeinander stehende Kippachsen 129 verkippbar sein. Er weist somit mindestens einen, insbesondere mindestens zwei Kipp-Freiheitsgrade auf. Durch Verkippung des Spiegels 129 können unterschiedliche Regionen 132ᵢ auf dem optischen Bauelement 52 mit der Laserstrahlung 127 beaufschlagt werden. Exemplarisch sind in der Fig. 19 zwei Kippstellungen des Spiegels 129 mit dem entsprechenden Strahlengang zu zwei unterschiedlichen Regionen 132₁, 132₂ auf dem optischen Bauelement 52 dargestellt. Durch eine Verkippung des Spiegels 129 und geeignete Verlagerung der Spiegelelemente 27 des Bauelements 52 lässt sich die Laserstrahlung 127 über die Oberfläche 126 verfahren. Hierbei kann durch eine Verlagerung der Spiegelelemente 27 des Bauelements 52 erreicht werden, dass die Laserstrahlung 127 jeweils auf die Oberfläche 126 fokussiert ist.

Das optische System 125 weist mit anderen Worten eine verstellbare effektive Brennweite fᵢ auf. Die Brennweite kann insbesondere zwischen einem minimalen Wert fₘᵢₙ und einem maximalen Wert fₘₐₓ verstellt werden. Die Differenz fₘₐₓ - fₘᵢₙ wird auch als Fokustiefe FT bezeichnet. Aufgrund der Verstellbarkeit der Spiegelelemente 27 des Bauelements 52 kann das optische System 125 prinzipiell eine große Fokustiefe FT aufweisen. Die Fokustiefe FT des optischen Systems 125 beträgt insbesondere mindestens 1 mm, insbesondere mindestens 1 cm, insbesondere mindestens 1 dm. Größere Fokustiefen FT, beispielsweise bis unendlich, sind ebenso möglich und je nach Brennweite und Verstellbereich der Einzelspiegel 27 denkbar, z. B. wenn die Strahlen parallel den Spiegel verlassen.

Außerdem kann durch eine Verlagerung der Einzelspiegel 27 erreicht werden, dass ein Einfallswinkel der Laserstrahlung 127, insbesondere der Hauptstrahlrichtung, an jedem Punkt der Oberfläche 126 in einem vorbestimmten Bereich liegt. Es kann insbesondere sichergestellt werden, dass der Einfallswinkel der Laserstrahlung 127, gemessen relativ zu einer Normalen 133 am jeweiligen Punkt der Oberfläche 126, höchstens 10°, insbesondere höchstens 5°, insbesondere höchstens 3° beträgt. Der Einfallswinkel kann insbesondere unabhängig von der lokalen Krümmung der Oberfläche 126 derart eingestellt werden, dass die Hauptstrahlrichtung im Wesentlichen senkrecht zur Oberfläche 126 ist. Das optische System 125 weist allgemein eine verstellbare Hauptstrahlrichtung auf.

Darüber hinaus kann die Fokusform, d. h. die Intensitätsverteilung im Bereich des Fokus, auf einen für die Anwendung vorteilhaften Verlauf gezielt eingestellt werden. Dies wird nachfolgend noch genauer beschrieben.

Die Kippstellung des Spiegels 129 sowie die Kippstellungen und/oder Spiegelhöhen der Einzelspiegel 27 des Bauelements 52 sind mittels der nur schematisch dargestellten zentralen Steuereinrichtung 153 steuerbar.

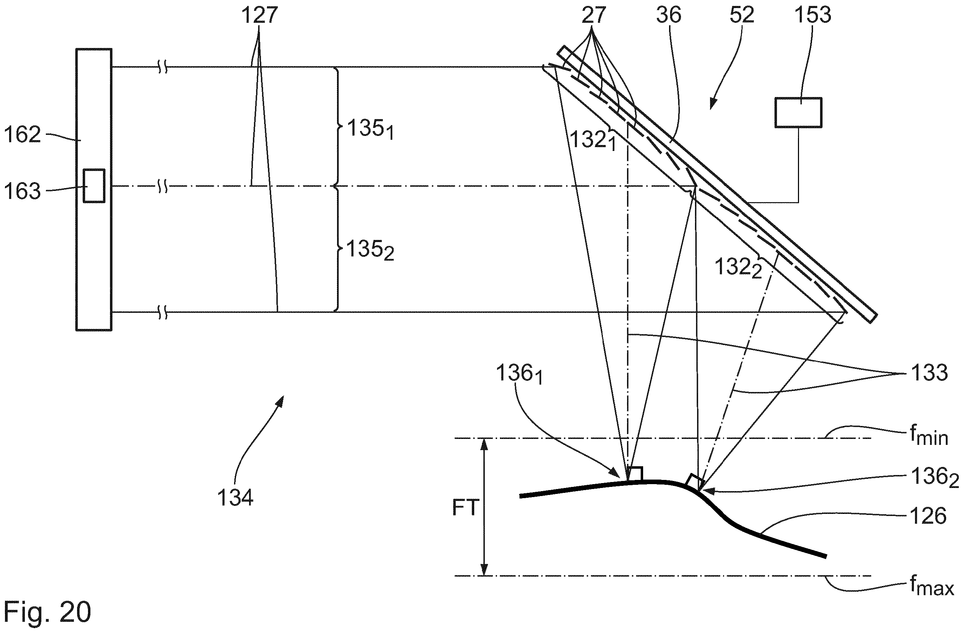

Gemäß der in Fig. 20 schematisch dargestellten Ausführungsform ist die Strahlführungsoptik als multifokale Vielstrahl-Scanoptik 134 ausgebildet. Dies bedeutet, dass mehrere Strahlen 135ᵢ gleichzeitig vom Beleuchtungssystem 162 zum optischen Bauelement 52 und von dort zur Oberfläche 126 geführt werden. Bei den Strahlen 135ᵢ kann es sich auch um Strahlenbündel mit mehreren Teilstrahlen handeln. Jede der Strahlen 135ᵢ wird auf eine vorbestimmte der Regionen 132ᵢ des optischen Bauelements 52 geführt und von dort auf die Oberfläche 126 fokussiert. Dabei können die Regionen 132ᵢ mehrere oder auch nur einen Spiegel 27 umfassen. Hierbei können unterschiedliche Strahlen 135ᵢ in unterschiedliche, insbesondere in räumlich getrennte Foki 136ᵢ auf der Oberfläche 126 fokussiert werden. Die Foki 136₁, 136₂ zweier Strahlungsbündel 135₁ und 135₂ gelten als unterschiedlich oder räumlich getrennt, wenn die Strahlung 10 des einen Fokus 136₁ nach Normierung der Intensität der jeweiligen Strahlungsbündel 135₁, 135₂ zur Strahlungsintensität des anderen Fokus 136₂ im Bereich derselben optischen Ebene höchstens 1% beiträgt. Die Foki 136ᵢ der unterschiedlichen Strahlen oder Strahlen 135ᵢ sind insbesondere unabhängig voneinander veränderbar. Durch Verlagerung der Einzelspiegel 27 kann insbesondere die effektive Brennweite fᵢ und/oder die Lage des jeweiligen Fokus 136ᵢ auf der Oberfläche 126 und/oder dessen Ausdehnung verändert werden. Die Foki 136ᵢ können räumlich voneinander getrennt sein. Sie können auch paarweise überlappend, insbesondere paarweise vollständig überlappend sein.

Sobald kohärentes Licht über mehr als einen Spiegel auf einem gemeinsamen Fokus gelenkt wird, muss die Phase der Lichtwellen so aufeinander abgestimmt sein, dass eine phasenrichtige Überlagerung der Lichtwellen die gewünschte Lichtverteilung ergibt. Durch eine lineare Verlagerung, d.h. durch eine Einstellung der Spiegelhöhe, lässt sich die Phase der jeweils von dem Einzelspiegel 27 reflektierten Lichtwelle steuern.

Sind die Phasenlagenunterschiede der von verschiedenen Spiegeln 127 überlagerten Lichtwellen größer als der Einstellbereich der Spiegelhöhen, so können diese um ein ganzzahliges Vielfaches der Lichtwellenlänge reduziert werden. Die geht jedoch nur bei ausreichender Kohärenzlänge und ausreichend geringem Wellenlängenspektrum des Nutzlichtes. Um diese Anforderungen zu reduzieren, ist es vorteilhaft Brechkraft vom Mikrospiegelarray zu nehmen. Dies kann durch eine Fokussierlinse 128 oder Scanlinse im Strahlengang erreicht werden. Bei großen Scanwinkeln treten auch schnell große Phasenlagenunterschiede auf. Auch hier ist es vorteilhaft, die große Scanbewegung durch eine Scanbewegung eines Scanspiegels 129 zu realisieren. Das Mikrospiegelarray übernimmt dann die Feineinstellung. Auch auf diese Weise nimmt man Brechkraft vom Mikrolinsenarray.

Die Reihenfolge der drei Komponenten Mikrospiegelarray 32, Optik, insbesondere Fokussierlinse 128 bzw. Scanlinse, und Scanspiegel 129 im Strahlengang kann dabei beliebig sein.

Mittels der Vielstrahl-Scanoptik 134 ist die Strahlung 10 von der Strahlungsquelle 163 in mindestens zwei, insbesondere mindestens drei, insbesondere mindestens fünf, insbesondere mindestens zehn unterschiedliche Foki 136ᵢ auf der Oberfläche 126 fokussierbar.

Durch Verlagerung der Spiegelelemente 27 des Bauelements 52 können die Strahlen 135ᵢ unabhängig voneinander verändert werden. Hierdurch wird die Lichtverteilung auf der Oberfläche 126 verändert. Dabei ist es insbesondere möglich durch eine gezielte Anordnung der Foki 136ᵢ der Strahlen 135ᵢ auf der Oberfläche 126, insbesondere durch eine teilweise überlappende Anordnung der Foki 136ᵢ eine vorgegebene Lichtverteilung zur Beleuchtung der Oberfläche 126 zu erreichen. Dabei ist - wie oben beschrieben - auf phasenrichtige Überlagerung der Lichtwellen zu achten. Bei einem Verfahren wird zunächst eine räumliche und/oder zeitliche Lichtverteilung zur Bearbeitung und/oder Untersuchung der Oberfläche 136 vorgegeben, welche dann durch eine gesteuerte Verlagerung der Spiegelelemente 27 erzeugt wird.

Im Folgenden werden exemplarisch mit der Scanoptik 134 erzeugbare Lichtverteilungen und deren mögliche Anwendungen beschrieben. Eine erste Lichtverteilung, welche durch Verlagerung der Spiegelelemente 27 des Bauelements 52 erzeugbar ist, ist eine Airy-Verteilung. Hierbei wird ein beugungsbegrenzter Gesamtfokus 136 durch Interferenz geeigneter kohärenter Teilstrahlen 135ᵢ erzeugt. Die Foki 136ᵢ der Strahlen 135ᵢ sind hierbei teilweise überlappend. Eine Airy-Verteilung ist insbesondere für eine Probe-Wechselwirkung mit hoher Ortsauflösung nützlich, beispielsweise für die Lasermaterialbearbeitung oder die Mikroskopie.

Eine weitere mit der Scanoptik 134 erzeugbare Verteilung ist die Kastenformverteilung ("Top Hat"). Hierbei wird eine zumindest annähernd konstante Intensität in einer vorgegebenen, beliebig geformten, Fläche erzeugt. Die Intensität fällt randseitig schnell auf Null ab. Schnell bedeutet hier einen Intensitätsabfall, der vorzugsweise nicht langsamer als um den Faktor 2 vom Intensitätsabfall einer beugungsbegrenzten Fokusverteilung (Airy-Verteilung) abfällt.

Eine Kastenformverteilung eignet sich insbesondere für eine flächenhafte Probe-bearbeitung mit vergleichsweise geringer Intensität, beispielsweise zur Laserbehandlung der Oberfläche 126 oder zur Bestrahlung ausgewählter Bereiche (region for interest) für die Photomanipulation in der Mikroskopie.

Eine weitere mit der Scanoptik 134 erzeugbare Lichtverteilung ist ein sogenannter Linienfokus. Bei dieser Verteilung wird eine zumindest weitestgehend konstante Intensität entlang einer vorgegebenen Linie erzeugt, welche am Rand schnell auf Null abfällt. Die Linie kann insbesondere parallel, senkrecht oder schräg zu einer Verfahrrichtung des Fokus 136 ausgerichtet sein. Diese Lichtverteilung eignet sich insbesondere für eine linienförmige Probebearbeitung mit vergleichsweise hoher Intensität, insbesondere zur Laserkristallisation von Silizium.

Eine weitere mit der Scanoptik 134 erzeugbare Lichtverteilung ist eine flexibel einstellbare verlängerte Fokuszone. Bei dieser Verteilung wird eine zumindest weitestgehend maximale Intensität im Fokus entlang einer Linie in Strahlrichtung erzeugt. Diese Lichtverteilung eignet sich insbesondere für das Laser-Schneiden von Materialien, die so dick sind, dass die "normale" Fokusform entlang der Strahlachse senkrechte Schneidflächen verhindern.

Eine weitere mit der Scanoptik 134 erzeugbare Verteilung ist eine Doppelmaximum-Verteilung. Bei dieser Verteilung werden entlang einer Verfahrrichtung des Fokus 136 zwei zeitlich aufeinanderfolgende Maxima erzeugt. Diese sind an eine komplexe Prozessfolge angepasst. Beispielsweise können in einer Gasphasenabscheidung Moleküle nahe der Oberfläche 126 durch Strahlung im ersten Maximum gespalten werden und Strahlung im zweiten Maximum dazu verwendet werden, die Reaktion der Spaltprodukte mit der Oberfläche 126 zu unterstützen. Dabei kann es für eine optimale Prozessierung vorteilhaft sein dass die beiden Foki aus Strahlung unterschiedlicher Wellenlänge erzeugt werden.

Als weiteres Beispiel kann beim Laserstrahlschneiden das erste Maximum das Material aufschmelzen und ein zweites Maximum das geschmolzene Material aus dem Schneidschlitz auswerfen. Aus mehreren Foki zusammengesetzte Bearbeitungszonen bringen beim Laserstrahlschneiden erhebliche Vorteile bei Schnittgeschwindigkeit und -qualität. Derartige Vielstrahlbearbeitungszonen für die in der Praxis relevante Bearbeitungsbedingungen, insbesondere wechselnde Schneidrichtung und unterschiedliche Geometrien, lassen sich mit den Mikrospiegelarrays 52 realisieren.

Des weiteren kann mit dem erfindungsgemäßen Vielstrahlsystem ein Interferenzmuster generiert werden. Hierbei können insbesondere flexibel einstellbare Streifenmuster zur strukturierten Beleuchtung der Oberfläche oder Probe 126 erzeugt werden. Das Streifenmuster kann eine bestimmte Orientierung und/oder eine bestimmte Gitterperiode aufweisen. Diese Lichtverteilung ist - wie oben beschrieben - insbesondere für mikroskopische Anwendungen nützlich.

Weitere Lichtverteilungen sind ebenso möglich.

Die Lichtverteilung kann mithilfe der Steuereinrichtung 153 vorgegeben werden. Es handelt sich allgemein um eine eindimensionale, zweidimensionale, dreidimensionale oder vierdimensionale Lichtverteilung. Unter Letzterer sei eine zeitlich veränderbare dreidimensionale Lichtverteilung verstanden. Als weitere Dimension kann die Lichtverteilung aus unterschiedlichen Wellenlängen zusammengesetzt sein. Es kann insbesondere vorgesehen sein, dass die Steuereinrichtung 153 eine bestimmte Auswahl an Lichtverteilungen für das Vielstrahlsystem zur Verfügung stellt. Diese Auswahl kann individuell erweiterbar sein.

Die Fokussierung der Strahlen 135ᵢ erfolgt wiederum durch eine Verlagerung, insbesondere eine Verkippung und/oder lineare Verlagerung der Spiegelelemente 27 des Bauelements 52. Die Fokussierung und/oder Ausrichtung der Strahlen 135ᵢ können jeweils unabhängig voneinander erfolgen. Hierdurch ist es insbesondere möglich, nicht nur getrennte Foki 136ᵢ auf der Oberfläche 126 gleichzeitig zu beleuchten, sondern auch Bereiche der Oberfläche 126 mit einer gegebenen Lichtverteilung zu beleuchten. Die lineare Verlagerung der Spiegelelemente 27 erlaubt eine phasenrichtige Überlagerung der von den Spiegelelementen 27 reflektierten Teilstrahlen der Strahlen 135ᵢ, um so die Fokusform gezielt einzustellen.

Bei der in Fig. 20 dargestellten Scanoptik 134 weist diese keine Fokussierlinse 128 und keinen Scanspiegel 129 auf. Es ist jedoch ebenso möglich, auch bei der Vielstrahl-Scanoptik 134 entsprechende Bauelemente vorzusehen. Hierbei kann insbesondere für jede der separaten Strahlen 135ᵢ eine separate Fokussierlinse 128ᵢ vorgesehen sein. Es kann auch eine gemeinsame Fokussierlinse 128 für sämtliche Strahlen135ᵢ vorgesehen sein. Ebenso sind ein oder mehrere Ablenkspiegel und/oder ein oder mehrere Strahlteiler samt Fokussiereinrichtungen möglich.

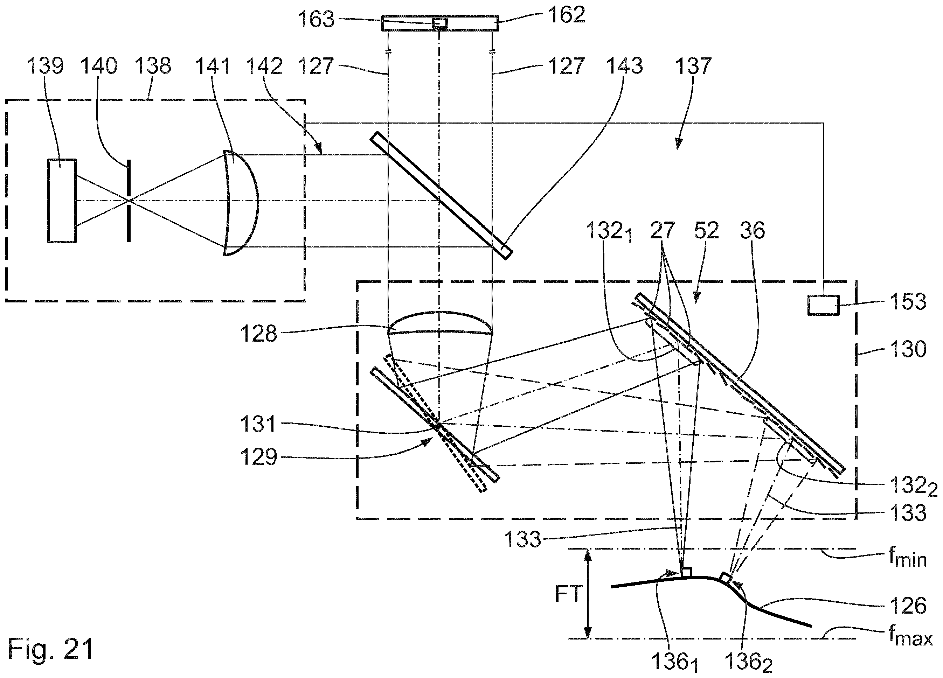

Eine weitere Scanoptik 137 ist in Fig. 21 dargestellt. Diese Ausführungsform entspricht im Wesentlichen der in Fig. 19 dargestellten, auf deren Beschreibung verwiesen wird.

Zusätzlich zu den Bestandteilen der in Fig. 19 dargestellten Scanoptik 137 umfasst diese eine Autofokus-Einrichtung 138. Die Autofokus-Einrichtung 138 umfasst einen Detektor 139, eine Lochblende 140 und eine Fokussierlinse 141. Es handelt sich insbesondere um eine konfokale Autofokus-Einrichtung 138. Mittels der Autofokus-Einrichtung 138 ist ein von der Oberfläche 126 reflektierter und/oder gestreuter Anteil 142 der Laserstrahlung 127 erfassbar. Der reflektierte oder gestreute Anteil 142 wird von der Oberfläche 126 über das optische Bauelement 52 und den Spiegel 129 zu einem Strahlteiler 143 geleitet und vom Strahlteiler 143 zur

Detektions-Einrichtung 139 umgelenkt. Die Detektions-Einrichtung erhält ein maximales Signal, wenn der Fokus 136ᵢ auf der Oberfläche 126 zu liegen kommt.

Der Strahlteiler 143 ist im Strahlengang zwischen der Strahlungsquelle 3 und dem optischen Bauelement 52 angeordnet,

Mittels der Autofokus-Einrichtung 138, insbesondere mittels der Detektions-Einrichtung 139 derselben ist insbesondere eine Bestimmung der Entfernung zwischen dem optischen Bauelement 52 und der Oberfläche 126 möglich.

Die Autofokus-Einrichtung 138 ist in signalübertragender Weise mit der zentralen Steuereinrichtung 153 verbunden. Die Autofokus-Einrichtung 138 und die zentrale Steuereinrichtung 153 bilden insbesondere Bestandteile einer Regelschleife zur Regelung der Positionen, insbesondere der Kippstellungen und/oder der Spiegelhöhen der Spiegelelemente 27 des Bauelements 52. Mittels der Regelschleife ist es möglich, die effektive Brennweite fᵢ der Scanoptik 137 derart zu regeln, dass die Detektions-Einrichtung 139 stets ein maximales Signal erhält. Bei einer spekular reflektierenden Oberfläche 126 ist das Signal am Detektor 139 maximal, wenn der Fokus in z-Richtung getroffen wird und gleichzeitig der Strahl auch senkrecht auf der Oberfläche 126 steht. Vorteilhaft ist hier die Auslegung des Detektors 130 als positionsempfindlicher Detektor (PSD; position sensitive detector) zur Bestimmung des Strahlschwerpunktes. So kann Strahlrichtung und z-Lage des Fokus unabhängig voneinander bestimmt und geregelt werden. Auf diese Weise lässt sich vor der Bearbeitung und/oder Untersuchung die zu bearbeitende und/oder untersuchende Oberfläche 126 dreidimensional erfassen oder während der Bearbeitung und/oder Untersuchung der Fokus 136ᵢ auf der Oberfläche 126 halten.

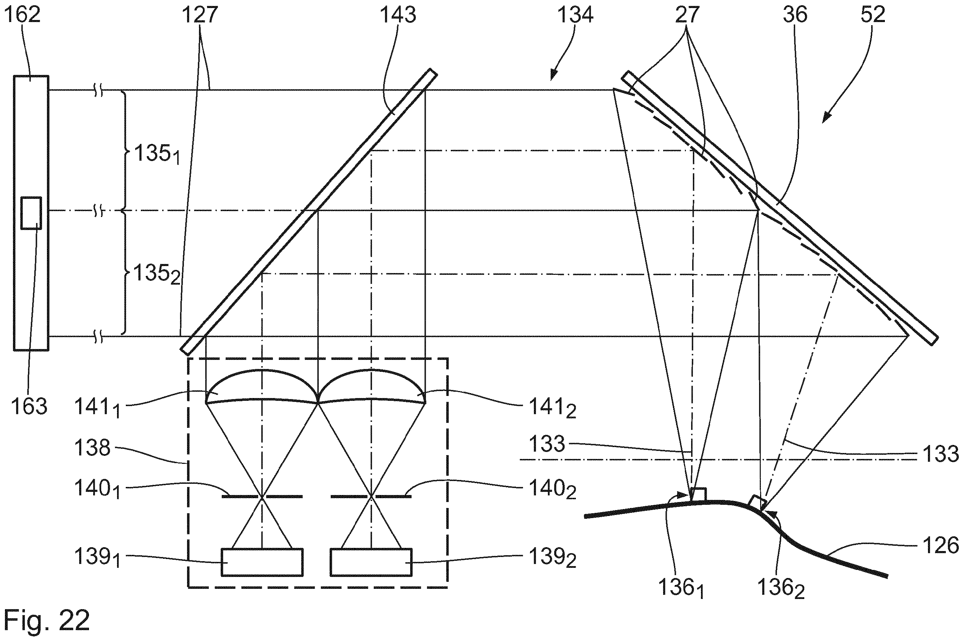

Wie in der Fig. 22 schematisch dargestellt ist, kann eine entsprechende Autofokus-Einrichtung 138 auch bei einer Vielstrahl-Scanoptik 134 entsprechend der in Fig. 20 dargestellten Form vorgesehen sein. Im Falle einer Vielstrahl-Scanoptik 134 umfasst die Autofokus-Einrichtung 138 jeweils für jede der Strahlen135ᵢ eine eigene Detektions-Einrichtung 139ᵢ, eine eigene Lochblende 140ᵢ und eine eigene Fokussierlinse 141ᵢ. In den Fig. 20 und 22 sind zur Verdeutlichung des Konzeps jeweils zwei Strahlen 135₁, 135₂ dargestellt. Mittels der Vielstrahl-Scanoptik 134 sind auch mehr als zwei Strahlen 135ᵢ unabhängig voneinander auf die Oberfläche 126 fokussierbar. Die Anzahl der Strahlen 135ᵢ kann insbesondere mindestens 3, insbesondere mindestens 10, insbesondere mindestens 100 betragen. Dies erhöht die Bearbeitungsgeschwindigkeit, setzt aber voraus, dass Laserstrahlung mit ausreichend hoher Intensität bzw. Leistung zur Verfügung steht.

Zur Bearbeitung und/oder Untersuchung der Oberfläche 126 mit der Laserstrahlung 127 wird diese von der Strahlungsquelle 163 mittels der Strahlführungsoptik 134 zur Oberfläche 126 geführt. Hierbei wird zur Einstellung einer vorgegebenen Hauptstrahlrichtung und/oder Fokustiefe und/oder Lichtverteilung zumindest bei einem Teil der Spiegelelemente 27 mittels der Steuereinrichtung 153 ein Kippwinkel und/oder eine Spiegelhöhe eingestellt.

## Patentansprüche

1. Optisches Bauelement (52) zur Führung mindestens eines Strahlungsbündels (10; 135ᵢ) umfassend
a. eine Vielzahl von Spiegel-Elementen (27), welche jeweils einen Spiegelkörper (35) mit einer Reflexionsfläche (34) mit einer zentralen Flächennormalen (340) aufweisen, und
b. eine Tragestruktur (36), welche mechanisch mit den Spiegel-Elementen (27) verbunden ist,
c. wobei zumindest ein Teil der Spiegel-Elemente (27) mittels ihnen jeweils zugeordneten elektromagnetischen Aktuatoren (50) relativ zur Tragestruktur (36)
i. in einer z-Richtung, welche parallel zur Flächennormalen (340) des jeweiligen Spiegel-Elements (27) in einer Mittelstellung verläuft, linear verlagerbar und
ii. aus der Mittelstellung um mindestens eine quer zur Flächennormalen (340) orientierte Kippachse verkippbar ist, und
d. wobei der Aktuator (50) jeweils mindestens eine erste, mit dem Spiegel-Element (27) verbundene Elektrode (44) und mindestens zwei zweite, mit der Tragestruktur (36) verbundene Elektroden (62ᵢ) umfasst,
e. wobei die mindestens zwei mit der Tragestruktur (36) verbundenen Elektroden (62ᵢ) jeweils zumindest eine in z-Richtung verlaufend angeordnete Teilelektrode umfassen,
f. wobei die Elektroden (44, 62ᵢ) derart ausgebildet und angeordnet sind, dass zwischen ihnen ein elektrisches Feld erzeugbar ist, dessen über die Erstreckung der ersten Elektrode (44) gemittelte Feldstärke eine Komponente in z-Richtung aufweist, und
g. wobei die mindestens eine erste Elektrode (44) auf einem sich in Richtung der Flächennormalen (340) erstreckenden, mit dem Spiegelkörper (35) verbundenen Aktuatorstift (43) angeordnet ist, und
h. wobei mindestens eine der Elektroden (44, 62ᵢ) mindestens zwei separate Teil-Elektroden (51; 49ᵢ, 49₂) umfasst, die in z-Richtung gegeneinander versetzt angeordnet sind und die unabhängig voneinander mit Spannung beaufschlagbar sind.

2. Optisches Bauelement (52) gemäß Anspruch 1, **dadurch gekennzeichnet, dass** die mit der Tragestruktur (36) verbundenen Elektroden (62ᵢ) jeweils auf einer den Aktuatorstift (43) in Richtung quer zur Flächennormalen (340) umgebenden, in der Tragestruktur (36) ausgebildeten Hülse angeordnet sind.

3. Optisches Bauelement (52) gemäß einem der Ansprüche 1 bis 2, **dadurch gekennzeichnet, dass** die Elektroden (44, 62ᵢ) unterschiedliche Längen in z-Richtung aufweisen.

4. Optisches Bauelement (52) gemäß einem der Ansprüche 1 bis 3, **dadurch gekennzeichnet, dass** der Aktuatorstift (43) einen runden oder einen elliptischen Querschnitt aufweist.

5. Optisches Bauelement (52) gemäß einem der Ansprüche 1 bis 4, **dadurch gekennzeichnet, dass** mindestens eine der Teil-Elektroden (51) quer zur z-Richtung ausgerichtet ist.

6. Verfahren zur Herstellung eines optischen Bauelements (52) gemäß einem der Ansprüche 1 bis 5 umfassend die folgenden Schritte:
- Bereitstellen
i. eines Substrats zur Herstellung einer Tragestruktur (36) für die Spiegel-Elemente (27) und
ii. eines vorprozessierten Spiegel-Array-Waferstacks,
- Strukturieren des Substrats mittels eines Ätzverfahrens,
- Abscheiden von Kontakt-Strukturen auf dem Substrat zur Herstellung von äußeren Elektroden (62i) und zentralen Elektroden (44),
- selektives Verkürzen der zentralen Elektroden (44) oder der äußeren Elektroden (62i), und
- Zusammenfügen des Spiegel-Array-Waferstacks mit dem Substrat.

7. Optisches System (1; 125; 137) zur Bearbeitung und/oder Untersuchung einer Oberfläche (6, 8; 126) umfassend
a. eine Strahlführungsoptik (4, 7; 130) mit einem optischen Bauelement (52) gemäß einem der Ansprüche 1 bis 5 und
b. eine Strahlungsquelle (3; 163).

8. Optisches System (1; 125; 137) gemäß Anspruch 7, **gekennzeichnet durch** eine verstellbare Brennweite (fᵢ).

9. Optisches System (1; 125; 137) gemäß einem der Ansprüche 7 bis 8, **gekennzeichnet durch** eine verstellbare Hauptstrahlrichtung.

10. Optisches System (1; 125; 137) gemäß einem der Ansprüche 7 bis 9, **gekennzeichnet durch** eine Detektions-Einrichtung (139) zur konfokalen Bestimmung einer Entfernung zwischen dem optischen Bauelement (52) und der zu bearbeitenden oder zu untersuchenden Oberfläche (6, 8; 126).

11. Optisches System (1; 125; 137) gemäß einem der Ansprüche 7 bis 10, **dadurch gekennzeichnet, dass** im Strahlengang zwischen der Strahlungsquelle (2; 162) der zu bearbeitenden oder zu untersuchenden Oberfläche (6, 8; 126) mindestens ein verkippbar gelagerter Spiegel (27; 129) angeordnet ist.

12. Optisches System (1; 125; 137) gemäß einem der Ansprüche 7 bis 11, **dadurch gekennzeichnet, dass** im Strahlengang zwischen der Strahlungsquelle (163) und dem optischen Bauelement (52) mindestens ein Strahlteiler (143) angeordnet ist.

13. Verfahren zur Bearbeitung und/oder Untersuchung einer Oberfläche mit Strahlung (10; 127) umfassend die folgenden Schritte:
a. Erzeugen von Strahlung (10; 127) mittels einer Strahlungsquelle (3; 163),
b. Führen mindestens eines Teils der Strahlung (10; 127) von der Strahlungsquelle (3; 163) zu einer Oberfläche mittels eines optischen Bauelements gemäß einem der Ansprüche 1 bis 5,
c. wobei zur Einstellung einer vorgegebenen Hauptstrahlrichtung und/oder Brennweite und/oder Fokusform, d. h. Intensitätsverteilung zumindest bei einem Teil der Spiegel-Elemente (27) mittels einer Steuereinrichtung (153) ein Kippwinkel und/oder eine Spiegelhöhe eingestellt wird.

## Claims

1. Optical component (52) for guiding at least one radiation bundle (10; 135ᵢ), comprising
a. a multiplicity of mirror elements (27), which each have a mirror body (35) with a reflection surface (34) with a central surface normal (340), and
b. a carrying structure (36), which is mechanically connected to the mirror elements (27),
c. wherein at least some of the mirror elements (27) are, by means of electromagnetic actuators (50) that are in each case assigned thereto, relative to the carrying structure (36)
i. linearly displaceable in a z-direction, which extends parallel to the surface normal (340) of the respective mirror element (27) in a central position, and
ii. tiltable from the central position about at least one tilt axis that is oriented transversely to the surface normal (340), and
d. wherein the actuator (50) comprises in each case at least one first electrode (44), connected to the mirror element (27), and at least two second electrodes (62ᵢ) that are connected to the carrying structure (36),
e. wherein the at least two electrodes (62ᵢ) connected to the carrying structure (36) comprise in each case at least one partial electrode arranged so as to extend in the z-direction,
f. wherein the electrodes (44, 62ᵢ) are embodied and arranged such that it is possible to generate between them an electrical field, the field strength of which, which is averaged over the extent of the first electrode (44), has a component in the z-direction, and
g. wherein the at least one first electrode (44) is arranged on an actuator pin (43), which extends in the direction of the surface normal (340) and is connected to the mirror body (35), and
h. wherein at least one of the electrodes (44, 62ᵢ) comprises at least two separate partial electrodes (51; 49i, 49₂), which are arranged offset with respect to one another in the z-direction and to which voltage can be applied independently from one another.

2. Optical component (52) according to Claim 1, **characterized in that** the electrodes (62ᵢ) connected to the carrying structure (36) are arranged each on a sleeve that is formed in the carrying structure (36) and surrounds the actuator pin (43) in the direction transversely to the surface normal (340).

3. Optical component (52) according to one of Claims 1 to 2, **characterized in that** the electrodes (44, 62ᵢ) have different lengths in the z-direction.

4. Optical component (52) according to one of Claims 1 to 3, **characterized in that** the actuator pin (43) has a round or an elliptical cross section.

5. Optical component (52) according to one of Claims 1 to 4, **characterized in that** at least one of the partial electrodes (51) is aligned transversely to the z-direction.

6. Method for producing an optical component (52) according to one of Claims 1 to 5, comprising the following steps:
- providing
i. a substrate for producing a carrying structure (36) for the mirror elements (27) and
ii. a pre-processed mirror array wafer stack,
- structuring the substrate by means of an etching method,
- depositing contact structures on the substrate for producing outer electrodes (62ᵢ) and central electrodes (44),
- selectively shortening the central electrodes (44) or the outer electrodes (62ᵢ), and
- assembling the mirror array wafer stack with the substrate.

7. Optical system (1; 125; 137) for processing and/or examining a surface (6, 8; 126), comprising
a. a beam-guiding optical unit (4, 7; 130) having an optical component (52) according to one of Claims 1 to 5 and
b. a radiation source (3; 163).

8. Optical system (1; 125; 137) according to Claim 7, **characterized by** an adjustable focal length (fᵢ).

9. Optical system (1; 125; 137) according to one of Claims 7 to 8, **characterized by** an adjustable main beam direction.

10. Optical system (1; 125; 137) according to one of Claims 7 to 9, **characterized by** a detection device (139) for the confocal determination of a distance between the optical component (52) and the surface (6, 8; 126) to be processed or to be examined.

11. Optical system (1; 125; 137) according to one of Claims 7 to 10, **characterized in that** at least one mirror (27; 129), which is mounted so as to be tiltable, is arranged in the beam path between the radiation source (2; 162) of the surface (6, 8; 126) to be processed or to be examined.

12. Optical system (1; 125; 137) according to one of Claims 7 to 11, **characterized in that** at least one beam splitter (143) is arranged in the beam path between the radiation source (163) and the optical component (52).

13. Method for processing and/or examining a surface using radiation (10; 127), comprising the following steps:
a. generating radiation (10; 127) by means of a radiation source (3; 163),
b. guiding at least some of the radiation (10; 127) from the radiation source (3; 163) to a surface by means of an optical component according to one of Claims 1 to 5,
c. wherein a tilt angle and/or a mirror height is set by means of a control device (153) for setting a specified main beam direction and/or focal length and/or focus shape, that is to say intensity distribution at least in some of the mirror elements (27).

## Revendications

1. Composant optique (52) pour guider au moins un faisceau de rayons (10 ; 135ᵢ), comprenant
a. une pluralité d'éléments de miroir (27) qui présentent respectivement un corps de miroir (35) doté d'une surface de réflexion (34) ayant une normale à la surface (340) centrale, et
b. une structure de support (36) qui est reliée mécaniquement aux éléments de miroir (27),
c. au moins une partie des éléments de miroir (27) pouvant être
i. décalée linéairement dans une direction z qui s'étend en parallèle à la normale à la surface (340) de l'élément de miroir (27) respectif dans une position centrale, et
ii. basculée hors de la position centrale autour d'au moins un axe de basculement orienté transversalement à la normale à la surface (340), par rapport à la structure de support (36) au moyen d'actionneurs électromagnétiques (50) qui leur sont associés respectivement, et
d. l'actionneur (50) comprenant respectivement au moins une première électrode (44) reliée à l'élément de miroir (27) et au moins deux deuxièmes électrodes (62ᵢ) reliées à la structure de support (36),
e. les au moins deux électrodes (62ᵢ) reliées à la structure de support (36) comprenant respectivement au moins une électrode partielle disposée en s'étendant dans la direction z,
f. les électrodes (44, 62ᵢ) étant réalisées et disposées de telle sorte qu'un champ électrique peut être produit entre celles-ci dont l'intensité de champ moyennée sur l'étendue de la première électrode (44) présente une composante dans la direction z, et
g. ladite au moins une première électrode (44) étant disposée sur une broche d'actionneur (43) reliée au corps de miroir (35) et s'étendant dans la direction de la normale à la surface (340), et
h. au moins l'une des électrodes (44, 62ᵢ) comprenant au moins deux électrodes partielles séparées (51 ; 49ᵢ, 49₂) qui sont disposées de manière décalée l'une par rapport à l'autre dans la direction z et qui peuvent être soumises à une tension indépendamment l'une de l'autre.

2. Composant optique (52) selon la revendication 1, **caractérisé en ce que** les électrodes (62ᵢ) reliées à la structure de support (36) sont disposées respectivement sur une douille réalisée dans la structure de support (36) et entourant la broche d'actionneur (43) dans la direction transversale à la normale à la surface (340).

3. Composant optique (52) selon l'une quelconque des revendications 1 à 2, **caractérisé en ce que** les électrodes (44, 62ᵢ) présentent différentes longueurs dans la direction z.

4. Composant optique (52) selon l'une quelconque des revendications 1 à 3, **caractérisé en ce que** la broche d'actionneur (43) présente une section transversale ronde ou elliptique.

5. Composant optique (52) selon l'une quelconque des revendications 1 à 4, **caractérisé en ce qu'**au moins l'une des électrodes partielles (51) est orientée transversalement à la direction z.

6. Procédé de fabrication d'un composant optique (52) selon l'une quelconque des revendications 1 à 5, comprenant les étapes suivantes consistant à :
- fournir
i. un substrat pour fabriquer une structure de support (36) pour les éléments de miroir (27), et
ii. une pile de plaquettes de matrice de miroirs prétraitée,
- structurer le substrat au moyen d'un procédé de gravure,
- déposer des structures de contact sur le substrat pour fabriquer des électrodes extérieures (62ᵢ) et des électrodes centrales (44),
- raccourcir sélectivement les électrodes centrales (44) ou les électrodes extérieures (62ᵢ), et
- assembler la pile de plaquettes de matrice de miroirs avec le substrat.

7. Système optique (1 ; 125 ; 137) permettant de traiter et/ou d'examiner une surface (6, 8 ; 126), comprenant
a. une optique de guidage de rayon (4, 7 ; 130) avec un composant optique (52) selon l'une quelconque des revendications 1 à 5, et
b. une source de rayonnement (3 ; 163).

8. Système optique (1 ; 125 ; 137) selon la revendication 7, **caractérisé par** une distance focale réglable (fᵢ).

9. Système optique (1 ; 125 ; 137) selon l'une quelconque des revendications 7 à 8, **caractérisé par** une direction de rayon principale réglable.

10. Système optique (1 ; 125 ; 137) selon l'une quelconque des revendications 7 à 9, **caractérisé par** un dispositif de détection (139) pour la détermination confocale d'une distance entre le composant optique (52) et la surface à traiter ou à examiner (6, 8 ; 126) .

11. Système optique (1 ; 125 ; 137) selon l'une quelconque des revendications 7 à 10, **caractérisé en ce qu'**au moins un miroir monté basculant (27 ; 129) est disposé sur la trajectoire des rayons entre la source de rayonnement (2 ; 162) de la surface à traiter ou à examiner (6, 8 ; 126).

12. Système optique (1 ; 125 ; 137) selon l'une quelconque des revendications 7 à 11, **caractérisé en ce qu'**au moins un séparateur de faisceaux (143) est disposé sur la trajectoire des rayons entre la source de rayonnement (163) et le composant optique (52).

13. Procédé permettant de traiter et/ou d'examiner une surface par rayonnement (10 ; 127), comprenant les étapes suivantes consistant à :
a. produire un rayonnement (10 ; 127) au moyen d'une source de rayonnement (3 ; 163),
b. guider au moins une partie du rayonnement (10 ; 127) de la source de rayonnement (3 ; 163) à une surface au moyen d'un composant optique selon l'une quelconque des revendications 1 à 5,
c. dans lequel, pour le réglage d'une direction de rayon principale prédéfinie et/ou d'une distance focale et/ou d'une forme de foyer, c'est-à-dire d'une distribution d'intensité, un angle de basculement et/ou une hauteur de miroir sont réglés au moyen d'un dispositif de commande (153) au moins pour une partie des éléments de miroir (27).
